(19) Europäisches Patentamt / European Patent Office / Office européen des brevets

(11) **EP 3 459 173 B1**

(12) **EUROPÄISCHE PATENTSCHRIFT**

(45) Veröffentlichungstag und Bekanntmachung des Hinweises auf die Patenterteilung:
**12.02.2020   Patentblatt 2020/07**

(21) Anmeldenummer: **17805153.8**

(22) Anmeldetag: **20.11.2017**

(51) Int Cl.:
**H03F 3/24** $^{(2006.01)}$

(86) Internationale Anmeldenummer:
**PCT/EP2017/079778**

(87) Internationale Veröffentlichungsnummer:
**WO 2018/108460 (21.06.2018 Gazette 2018/25)**

(54) **VERFAHREN UND VORRICHTUNG ZUM SENDEN BZW. EMPFANGEN VON MINDESTENS EINEM HOCHFREQUENZSIGNAL MIT PARALLELER UND UNTERABGETASTETER BASISBANDSIGNALVERARBEITUNG**

METHOD AND DEVICE FOR TRANSMITTING OR RECEIVING AT LEAST ONE HIGH-FREQUENCY SIGNAL USING PARALLEL AND UNDERSAMPLED BASEBAND SIGNAL PROCESSING

PROCÉDÉ ET DISPOSITIF D'ENVOI OU DE RÉCEPTION D'AU MOINS UN SIGNAL À HAUTE FRÉQUENCE AVEC TRAITEMENT DE SIGNAL EN BANDE DE BASE PARALLELE ET SOUS-ÉCHANTILLONNÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.12.2016   DE 102016014795**

(43) Veröffentlichungstag der Anmeldung:
**27.03.2019   Patentblatt 2019/13**

(73) Patentinhaber: **Rosenberger Hochfrequenztechnik GmbH & Co. KG 83413 Fridolfing (DE)**

(72) Erfinder:
• **ALETSEE, Franz G. 86150 Augsburg (DE)**
• **STOLLE, Reinhard 86561 Aresing (DE)**

(56) Entgegenhaltungen:
EP-A2- 1 507 341          US-A1- 2005 099 327
US-A1- 2005 099 327     US-B1- 7 450 911

• ZHIGUO SONG ET AL: "Synthesis of complex subband Hybrid Filter Banks A/D converters using adaptive filters", ELECTRONICS, CIRCUITS, AND SYSTEMS, 2009. ICECS 2009. 16TH IEEE INTERNATIONAL CONFERENCE ON, IEEE, PISCATAWAY, NJ, USA, 13 December 2009 (2009-12-13), pages 399-402, XP031626307, ISBN: 978-1-4244-5090-9

EP 3 459 173 B1

**Beschreibung**

Die Erfindung betrifft ein Verfahren und eine Vorrichtung zum Senden bzw. Empfangen von mindestens einem Hochfrequenzsignal mit paralleler und unterabgetasteter Basissignalverarbeitung und ein System zum Übertragen von mindestens einem Hochfrequenzsignal mit paralleler und unterabgetasteter Basisbandsignalverarbeitung.

Das ständig steigende Datenvolumen, das in allen technischen Bereichen zu übertragen ist, erfordert verstärkt immer höhere Datenraten in der Datenübertragung und somit immer höhere Bandbreiten des hochfrequenten Trägersignals. Technische Geräte bzw. technische Systeme, die ein mit Daten moduliertes Hochfrequenzsignal empfangen bzw. erfassen, führen häufig eine Analog-Digital-Wandlung in Kombination mit einer Mischung ins Basisband durch. Im digitalen Basisband erfolgt die weitere Signal- und Datenverarbeitung.

Eine Analog-Digital-Wandlung eines sehr hochfrequenten Signals erfolgt parallelisiert in mehreren parallel geschalteten Analog-Digital-Wandlern. Jeder einzelne Analog-Digital-Wandler tastet hierbei sequenziell aufeinanderfolgend einen bestimmten Signalabschnitt des Hochfrequenzsignals ab. Eine derart zeitlich verschachtelte Analog-Digital-Wandlung (englisch: time interleaved analog-to-digital converting) ist beispielsweise in der US 9,264,059 B2 beschrieben. Die Parallelisierung ermöglicht bei begrenzter Signalverarbeitungsleistung jedes einzelnen Analog-Digital-Wandlers eine dem Nyquist-Kriterium entsprechende Abtastrate für sehr hochfrequente Signale zu realisieren.

Eine vollständige Erfassung des analogen Hochfrequenzsignals aus dem zugehörigen abgetasteten Hochfrequenzsignal erfordert einerseits ein exaktes Einhalten des Phasenversatzes zwischen jeweils zwei aufeinanderfolgend abtastenden Analog-Digital-Wandlern. Andererseits müssen alle parallel abtastenden Analog-Digital-Wandler ein identisches Signalverarbeitungsverhalten, beispielsweise eine identische Verstärkung, eine identische Quantisierungskennlinie und keinen Offset, aufweisen.

Zeitlich verschachtelt abtastende Analog-Digital-Wandler genügen diesen Anforderungen nicht. Zur Minimierung dieses negativen technischen Effekts weisen zeitlich verschachtelt abtastende Analog-Digital-Wandler nachteilig sehr aufwendig realisierte Kompensations-oder Entzerrungs-Einrichtungen auf, die die auftretenden Ungenauigkeiten oftmals nur minimieren, aber nicht vollständig kompensieren.

Senderseitig sind zur Übertragung eines hohen Datenvolumens in einem Hochfrequenzsignal auch mehrere parallel arbeitende Digital-Analog-Wandler möglich. Die von den parallel arbeitenden Digital-Analog-Wandlern jeweils erzeugten analogen Basisbandsignale sind über jeweils einen Mischer auf jeweils einen hochfrequenten Träger zu mischen, der sich jeweils in einem unterschiedlichen Frequenzbereich innerhalb des zu übertragenden Hochfrequenzsignals befindet. Die parallel geschalteten Mischer und die zugehörige Trägersignalgenerierung sind nachteilig auch mit einem hohen Implementierungsaufwand verbunden.

Aus der US 2005/099327 A1 ist eine Digital-zu-Analog-Wandlung mithilfe eines Delta-Sigma-Modulators und eines Digital-zu-Analog-Wandlers bekannt. Hierbei wird im Delta-Sigma-Modulator die Abtastrate des digitalen Signals mittels Überabtastung erhöht.

Aus Zhiglio Song et al.: "Synthesis of complex subband Hybrid Filter Banks A/D converters using adaptive filters", ELECTRONICS, CIRCUITS AND SYSTEMS, 2009, ICECS 2009, 16th IEEE INTERNATIONAL CONFERENCE ON, IEEE, PISCATAWAY, NJ, USA, 13. Dezember 2009 (2009-12-13), Seiten 399-402, XP031626307, ISBN: 978-1-4244-5090-9 geht eine parallele Analog-zu-Digital-Wandlung mit jeweils vorgeschalteter Bandpassfilterung und nachgeschalteter Entzerrung hervor. Die Analog-zu-Digital-Wandlung erfolgt hierbei in Unterabtastung. Die Entzerrung wird im Zeitbereich durchgeführt.

Aufgabe der Erfindung ist es deshalb, ein Verfahren und eine Vorrichtung zum Senden und Empfangen von sehr hochfrequenten Signalen zu schaffen, die die genannten technischen Nachteile nicht aufweisen. Der Gegenstand der Erfindung ist in den Ansprüchen definiert.

Die Aufgabe wird empfangsseitig durch ein erfindungsgemäßes Verfahren zum Empfangen von mindestens einem Hochfrequenzsignal mit paralleler und unterabgetasteter Basisbandsignalverarbeitung mit den Merkmalen des Patentanspruchs 1 und durch eine erfindungsgemäße Vorrichtung zum Empfangen von mindestens einem Hochfrequenzsignal mit paralleler und unterabgetasteter Basisbandsignalverarbeitung mit den Merkmalen des Patentanspruchs 10, gelöst. Senderseitig wird die Aufgabe durch ein erfindungsgemäßes Verfahren zum Senden von mindestens einem Hochfrequenzsignal mit paralleler und unterabgetasteter Basisbandsignalverarbeitung mit den Merkmalen des Patentanspruchs 8 und durch eine erfindungsgemäße Vorrichtung zum Senden von mindestens einem Hochfrequenzsignal mit paralleler und unterabgetasteter Basisbandsignalverarbeitung mit den Merkmalen des Patentanspruchs 16 gelöst. Ein erfindungsgemäßes System zum Übertragen von mindestens einem Hochfrequenzsignal mit paralleler und unterabgetasteter Basisbandsignalverarbeitung löst die Aufgabe auch. Vorteilhafte technische Erweiterungen der Erfindung sind in den jeweils abhängigen Patentansprüchen aufgeführt.

Erfindungsgemäß wird das einzelne empfangene oder erfasste Hochfrequenzsignal mehreren parallel verschalteten Filtern zugeführt, die jeweils einen unterschiedlichen Filterfrequenzgang aufweisen. Der Ausgang jedes Filters ist mit dem Eingang eines zugehörigen Analog-Digital-Wandlers verbunden. Jeder Analog-Digital-Wandler führt erfindungsgemäß eine Unterabtastung des vom zugehörigen Filter zugeführten gefilterten Signals durch.

Unter einer Unterabtastung wird im Folgenden eine Abtastung eines analogen Signals in ein zugehöriges digitalisiertes Signal verstanden, bei der die Abtastfrequenz kleiner, bevorzugt sehr viel kleiner, als der zweifache Wert der im analogen Signal enthaltenen höchsten Spektralfrequenz ist. Eine Unterabtastung genügt folglich dem in der digitalen Signalverarbeitung bekannten Nyquist-Kriterium nicht, das für eine korrekte Rekonstruktion des analogen Signals aus dem zugehörigen digitalisierten Signal eine Abtastfrequenz festlegt, die mindestens dem zweifachen Wert der im analogen Signal enthaltenen höchsten Spektralfrequenz entspricht.

Unter einem gefilterten Signal wird im Folgenden ein Signal verstanden, das am Ausgang eines Filters erzeugt wird und somit anliegt. Die Spektralanteile eines derartigen gefilterten Signals sind folglich im Wesentlichen auf den Durchlassfrequenzbereich des Filters begrenzt.

Aus jedem digitalisierten gefilterten Signal am Ausgang eines jeweiligen Analog-Digital-Wandlers werden erfindungsgemäß die zugehörigen Basisbandsignalanteile ermittelt. Unter den Basisbandsignalanteilen des digitalisierten Bandpass-Signals werden alle Spektralanteile des digitalisierten gefilterten Signals verstanden, die innerhalb des digitalen Basisbands liegen. Das digitale Basisband erstreckt sich im Spektralbereich von der negativen halben Abtastfrequenz bis zur positiven halben Abtastfrequenz.

Schließlich werden sämtliche Signalanteile des Hochfrequenzsignals im digitalen Basisband dadurch gewonnen, dass die Basisbandsignalanteile der einzelnen digitalisierten gefilterten Signale einer Entzerrung zugeführt werden.

Eine Abtastung eines analogen Signals bewirkt, dass sich das Spektrum des zugehörigen digitalisierten Signals aus der Überlagerung des sich periodisch wiederholenden Spektrums des analogen Signals zusammensetzt, wobei sich das Spektrum des analogen Signals in einem Frequenzraster von jeweils einer Abtastfrequenz wiederholt. Erfolgt eine Unterabtastung des analogen Signals, so überlagern sich die einzelnen sich wiederholenden Spektren des analogen Signals. Diese Überlagerung wird als Aliasing (deutsch: Abtaststörung) bezeichnet.

Betrachtet man ein mit einem hohen Datenvolumen moduliertes Hochfrequenzsignal, so befindet sich dieses hohe Datenvolumen in unterschiedlichen Frequenzbereichen des Hochfrequenzsignals, d.h. in unterschiedlichen Frequenzbändern des Hochfrequenzsignals. Ein derartiges Hochfrequenzsignal weist somit typischerweise eine Vielzahl von in unterschiedlichen Frequenzbändern jeweils befindlichen Spektralanteilen auf.

Durch die periodische Fortsetzung des zu einem derartigen Hochfrequenzsignal gehörigen Spektrums im Frequenzraster in Höhe von einer Abtastfrequenz überlagern sich im Fall einer Unterabtastung die einzelnen Spektralanteile des Hochfrequenzsignals jeweils vollständig innerhalb jedes aufeinanderfolgenden Frequenzabschnittes, der jeweils eine Bandbreite von einer Abtastfrequenz aufweist.

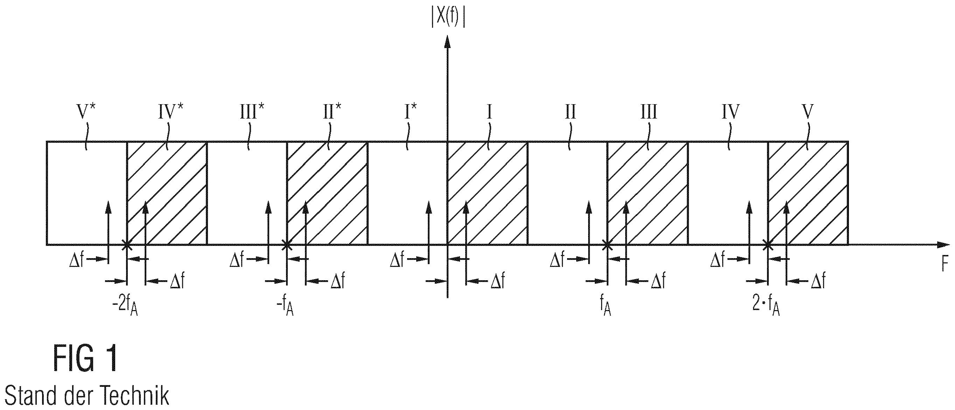

Gemäß Fig. 1 wird der positive und der konjugiert komplexe negative Spektralbereich eines reellen Signals in einzelne zueinander benachbarte Frequenzbereiche aufgeteilt, die jeweils eine Bandbreite in Höhe von einer halben Abtastfrequenz aufweisen und als erste Nyquist-Zone, zweite Nyquist-Zone, dritte Nyquist-Zone usw. bezeichnet werden. In der den positiven Frequenzen jeweils zugeordneten Hälfte des Basisbandes, d.h. in der ersten Nyquist-Zone, überlagern sich die Spektralanteile aller ungeraden Nyquist-Zonen des positiven Frequenzbereiches und aller geraden Nyquist-Zonen des negativen Frequenzbereiches. In der den negativen Frequenzen jeweils zugeordneten Hälfte des Basisbandes überlagern sich die Spektralanteile aller geraden Nyquist-Zonen des positiven Frequenzbereiches und aller ungeraden Nyquist-Zonen des negativen Frequenzbereiches.

Somit überlagern sich alle Spektralanteile des Hochfrequenzsignals, die sich vor der Unterabtastung über die Bandbreite des Hochfrequenzsignals verteilen, nach einer Unterabtastung innerhalb des Basisbandes.

Die einzelnen Filter weisen erfindungsgemäß jeweils einen unterschiedlichen Filterfrequenzgang auf, wobei sich die einzelnen Filterfrequenzgänge im Spektralbereich jeweils vollständig oder nur teilweise oder überhaupt nicht überlagern können.

Die Spektralanteile des einzelnen Hochfrequenzsignals werden entsprechend der unterschiedlichen Filterfrequenzgänge der parallel geschalteten Filter unterschiedlich auf die einzelnen Basisbandsignalanteile der zugehörigen digitalisierten gefilterten Signale abgebildet.

Die Filterung des einzelnen Hochfrequenzsignals mit jeweils mehreren Filtern, die jeweils einen unterschiedlichen Filterfrequenzgang aufweisen, stellt eine Verzerrung und Verkopplung der Signalanteile in einzelnen Spektralbereichen des Hochfrequenzsignals in mehreren Signalpfaden dar. Mittels geeigneter Entzerrung und Entkopplung der Basisbandsignalanteile aller digitalisierten gefilterten Signale werden die einzelnen Signalanteile in den einzelnen Spektralbereichen des einzelnen Hochfrequenzsignals ermittelt.

Die parallele Filterung des Hochfrequenzsignals, die jeweils mit unterschiedlichen Filterfrequenzgängen durchgeführt wird, in Kombination mit der Unterabtastung der einzelnen gefilterten Signale ermöglicht vorteilhaft eine Analog-Digital-Wandlung eines Hochfrequenzsignals, bevorzugt eines sehr breitbandigen Signals, mit einer vergleichsweise geringen Abtastfrequenz. Zusätzlich entfällt vorteilhaft die bei einer zeitlich verschachtelten Analog-Digital-Wandelung erforderliche aufwändige Phasenversatz-Steuerung und -Kontrolle.

Decken die Filterfrequenzgänge mehrerer Filter jeweils eine oder mehrere Nyquist-Zonen parallel ab, so wird auf diese Weise Diversität geschaffen. Diese Diversität ermöglicht vorteilhaft eine Erhöhung der Entzerrungsqualität, da in die Entzerrung die Signalanteile von einer Nyquist-Zone oder mehreren Nyquist-Zonen mehrfach, d. h. redundant, eingehen.

In einer bevorzugten Ausprägung der Erfindung decken die Filterfrequenzgänge aller benutzten parallelen Filter in Kombination das gesamte Frequenzspektrum des Hochfrequenzsignals ab. Auf diese Weise ist es vorteilhaft möglich, die Signalanteile in allen Frequenzbändern des Hochfrequenzsignals einer Basisbandsignalverarbeitung und einer sich daran anschließenden Datenverarbeitung zuzuführen.

Bevorzugt ist die Unterabtastung in allen Analog-Digital-Wandlern mit derselben Abtastfrequenz durchzuführen. Auf diese Weise wird gewährleistet, dass die Nyquist-Zonen und damit auch das digitale Basisband in allen digitalisierten gefilterten Signalen jeweils eine gleiche Bandbreite aufweisen. Auch ist die Anordnung der Nyquist-Zonen der einzelnen Ordnungen im Spektralbereich bei allen digitalisierten gefilterten Signalen jeweils gleich.

Auf diese Weise ist vorteilhaft gewährleistet, dass die Entzerrung und Entkopplung der Basisbandsignalanteile der einzelnen digitalisierten gefilterten Signale hinsichtlich der Signalanteile in den einzelnen Nyquist-Zonen zueinander frequenzmäßig abgestimmt ist.

Ist in einer weiteren bevorzugten Ausprägung der Erfindung die Unterabtastung in allen parallelen Analog-Digital-Wandlern kohärent, d.h. phasensynchron, ausgeführt, so ist es vorteilhaft möglich, als Hochfrequenzsignal ein DMT (Discrete-Multi-Tone)-Signal zu verwenden. Die Kohärenz der Unterabtastung in den einzelnen Analog-Digital-Wandlern garantiert, dass die einzelnen Träger des DMT-Signals, die in unterschiedlichen Frequenzbereichen liegen und damit unter Umständen von unterschiedlichen Analog-Digital-Wandlern abgetastet werden, phasensynchron abgetastet werden. Die phasensynchrone Abtastung der einzelnen Träger des DMT-Signals garantiert wiederum, dass die erforderliche Orthogonalität zwischen den einzelnen Trägern des DMT-Signals auch zwischen den Analog-Digital-Wandlern erhalten bleibt. Wird anstelle einer Basisbandübertragung ein trägerfrequentes Signal verwendet, kann OFDM (Orthogonal-Frequency-Division-Multiplexing) verwendet werden.

Die Entzerrung und Entkopplung der Basisbandsignalanteile der einzelnen digitalisierten gefilterten Signale erfolgt in einer ersten Ausführungsform der Erfindung im Zeitbereich:
Hierbei werden die Signalanteile des Hochfrequenzsignals in einzelnen Spektralbereichen, die jeweils einer bestimmten Nyquist-Zone des Hochfrequenzsignals entsprechen, mittels Entzerrung der Basisbandsignalanteile der einzelnen digitalisierten gefilterten Signale ermittelt:
Hierzu werden für die Bestimmung der Signalanteile des Hochfrequenzsignals in einem derartigen Spektralbereich die Basisbandsignalanteile der einzelnen digitalisierten gefilterten Signale jeweils einem digitalen Entzerrungsfilter zugeführt und die an den Ausgängen der einzelnen digitalen Entzerrungsfilter anliegenden digitalisierten Signale in einem anschließenden Summations-Glied summiert. Unter einem Entzerrungsfilter wird hierbei und im Folgenden ein digitales Filter verstanden, das die im Filter des digitalisierten gefilterten Signals verursachte Verzerrung entzerrt. Zusätzlich ist das Entzerrungsfilter so ausgelegt, dass sich nach Summation mit allen anderen Entzerrungsfiltern nur eine jeweils dem Entzerrungs- und Entkopplungskanal zugewiesene Nyquist-Zone übrig bleibt.

Für die Bestimmung der Signalanteile des Hochfrequenzsignals in allen Spektralbereichen ist somit eine Entzerrungs- und Entkopplungs-Einheit erforderlich, die eine der Anzahl von Nyquist-Zonen des digitalisierten Hochfrequenzsignals entsprechende Anzahl von Entzerrungs- und Entkopplungs-Kanälen umfasst. Jeder Entzerrungs- und Entkopplungs-Kanal wiederum umfasst eine der Anzahl von parallel geschalteten Filtern entsprechende Anzahl von digitalen Entzerrungsfiltern und ein den einzelnen digitalen Entzerrungsfiltern jeweils nachgeschaltetes Summations-Glied.

Unter einer Entzerrungs- und Entkopplungs-Einheit wird hierbei und im Folgenden eine Funktionseinheit verstanden, die aus den Basisbandsignalanteilen jedes digitalisierten gefilterten Signals die digitalisierten Signalanteile des Hochfrequenzsignals in den einzelnen Frequenzbereichen ermittelt, die jeweils den einzelnen Nyquist-Zonen des digitalisierten Hochfrequenzsignals entsprechen. Hierbei werden nicht nur die in den einzelnen Frequenzbereichen jeweils enthaltenen Signalanteile des Hochfrequenzsignals entkoppelt, sondern auch die in den einzelnen Filtern jeweils verursachten Verzerrungen rückgängig gemacht.

Unter einem Entzerrungs- und Entkopplungs-Kanal wird hierbei und im Folgenden die Ermittlung der digitalisierten Signalanteile des Hochfrequenzsignals in einem einzigen Frequenzbereich, der einer einzigen zugehörigen Nyquist-Zone des Hochfrequenzsignals entspricht, aus den Basisbandsignalanteilen aller digitalisierten gefilterten Signale verstanden. Eine Entzerrungs- und Entkopplung-Einheit umfasst folglich eine der Anzahl von betrachteten Nyquist-Zonen entsprechende Anzahl von Entzerrungs- und Entkopplungs-Kanälen.

Liegt der Sonderfall vor, dass jedes Filter jeweils einzig einen Spektralbereich des Hochfrequenzsignals selektiert, der jeweils einer unterschiedlichen Nyquist-Zone des digitalisierten Hochfrequenzsignals entspricht, so ist die Entzerrung der Basisband-Signalanteile der einzelnen digitalisierten Bandpass-Signale voneinander entkoppelt. Hierzu sind die Basisbandsignalanteile jedes einzelnen digitalisierten gefilterten Signals vorteilhaft jeweils nur einem digitalen Entzerrungsfilter zuzuführen. Das jeweilige digitale Entzerrungsfilter liefert hierbei die Signalanteile des Hochfrequenzsignals in einem bestimmten Spektralbereich. Ein nachgeschaltetes Summier-Glied ist in diesem Fall nicht erforderlich.

In einer zweiten bevorzugten Ausführungsform der Erfindung erfolgt die Entzerrung der Basisband-Signalanteile der einzelnen digitalisierten gefilterten Signale im Spektralbereich:

Hierzu sind die einzelnen digitalisierten gefilterten Signale jeweils einem Spektral-Transformator zugeführt.

Bevorzugt ist der Spektraltransformator als Fourier-Transformator realisiert. Dem Fourier-Transformator ist optional ein digitales Filter zur Verkürzung der Kanalimpulsantwort und eine Einheit zum Entfernen des Guard-Intervalls (deutsch: Schutz-Intervall) vorgeschaltet. Am Ausgang des Fourier-Transformators steht das diskrete Fourier-Spektrum des digitalisierten gefilterten Signals an.

Anschließend werden einzig die im digitalen BasisbandSpektrum befindlichen komplex-wertigen Spektralwerte des diskreten Spektrums der einzelnen digitalisierten gefilterten Signale weiterverfolgt.

Für die Bestimmung der Signalanteile des Hochfrequenzsignals in einem bestimmten Spektralbereich, der einer bestimmten Nyquist-Zone des Hochfrequenzsignals entspricht, wird für jede Frequenz im digitalen Basisband, an der sich ein Spektralwert der einzelnen digitalisierten gefilterten Signale befindet, jeweils der Spektralwert des einzelnen digitalisierten gefilterten Signals mit einem zugehörigen spektralen Entzerrungs-Koeffizienten multipliziert. Unter einem spektralen Entzerrungskoeffizienten versteht man hierbei und im Folgenden den Spektralwert der Übertragungsfunktion eines zugehörigen Entzerrungsfilters bei der betrachteten Frequenz.

Im Anschluss werden für eine betrachtete Frequenz die mit den zugehörigen spektralen Entzerrungskoeffizienten jeweils multiplizierten Spektralwerte der einzelnen digitalisierten gefilterten Signale summiert.

Dieser Vorgang der einzelnen Multiplikationen und der anschließenden Summation wird für jeden Frequenzpunkt innerhalb des digitalen Basisbands, bei dem jeweils ein Spektralwert der einzelnen digitalisierten gefilterten Signale vorliegt, durchgeführt.

Eine Entzerrungs- und Entkopplungs-Einheit im Spektralbereich umfasst also eine der Anzahl von betrachteten Nyquist-Zonen entsprechende Anzahl von Entzerrungs- und Entkopplungs-Kanälen, die jeweils einzelne Multiplizier-Glieder und ein nachgeschaltetes Summations-Glied aufweisen.

Für den Sonderfall einer entkoppelten Entzerrung der Basisbandsignalanteile der einzelnen digitalisierten gefilterten Signale werden die Spektralanteile der einzelnen digitalisierten gefilterten Signale im digitalen Basisband einzig mit einem zugehörigen spektralen Entzerrungskoeffizienten multipliziert. Eine anschließende Summation der Multiplikationsergebnisse ist in diesem Fall nicht erforderlich.

In einer bevorzugten Weiterentwicklung des erfindungsgemäßen Verfahrens und der erfindungsgemäßen Vorrichtung zum Empfangen von mindestens einem Hochfrequenzsignal mit paralleler und unterabgetasteter Basisbandsignalverarbeitung wird in der Entzerrung nicht nur die Verzerrung im jeweiligen Filter, sondern auch die Verzerrung im zugehörigen Analog-Digital-Wandler, die Verzerrung im Übertragungskanal und/oder die Verzerrung beim Erzeugen des zu übertragenden Hochfrequenzsignal, insbesondere die Verzerrung in den Senderfiltern, berücksichtigt.

Erfindungsgemäß werden senderseitig die in einem Hochfrequenzsignal jeweils zu übertragenden digitalen Basisband-Signale jeweils einem Digital-Analog-Wandler zur Erzeugung eines zugehörigen analogen Signals zugeführt. Bei den einzelnen digitalen Signalen ist die Abtastrate des jeweiligen digitalen Signals so zu bemessen, dass sie kleiner, bevorzugt deutlich kleiner, als die doppelte höchste Spektralfrequenz im zugehörigen analogen Signal ist.

Da sich das Spektrum eines analogen Signals in einem korrespondierenden digitalen Signal im Raster der Abtastfrequenz periodisch fortsetzt, überlagern sich die einzelnen Spektralanteile des digitalen Signals jeweils vollständig innerhalb jedes aufeinanderfolgenden Frequenzabschnittes, der jeweils eine Bandbreite von einer Abtastfrequenz aufweist.

Ein jedem Digital-Analog-Wandler jeweils nachfolgendes Filter erzeugt ein zum jeweiligen analogen Signal korrespondierendes gefiltertes Signal. Die Filterfrequenzgänge der einzelnen Filter unterscheiden sich voneinander, wobei sich die einzelnen Filterfrequenzgänge im Spektralbereich jeweils vollständig oder nur teilweise oder überhaupt nicht überlagern können. Die Filterfrequenzgänge der einzelnen Filter decken in Summe das gesamte analoge Spektrum ab.

In einem Sonderfall erstreckt sich der Filterfrequenzgang jedes einzelnen Filters jeweils über den Frequenzbereich einer unterschiedlichen Nyquist-Zone der einzelnen digitalen Signale. Auf diese Weise lässt sich für jedes einzelne digitale Signal jeweils eine andere Nyquist-Zone auswählen. Die in der einzelnen Nyquist-Zone jeweils befindlichen Spektralanteile umfassen die vollständigen und nicht widerholten Spektralanteile des zugehörigen analogen Signals. Somit lassen sich für den Sonderfall durch das Filtern die wiederholten Spektralanteile jedes einzelnen digitalen Signals in einem unterschiedlichen, der jeweiligen Nyquist-Zone entsprechenden Frequenzbereich selektieren.

Durch Summieren der einzelnen gefilterten Signale zum zu sendenden Hochfrequenzsignal gewinnt man vorteilhaft ohne Mischen ein Hochfrequenzsignal.

Ist jeder einzelne Digital-Analog-Wandler jeweils mit der gleichen Taktquelle verbunden, so dass jeder Digital-Analog-Wandler den gleichen Takt erhält, so befinden sich die einzelnen Nyquist-Zonen bei allen digitalen Signalen jeweils in den gleichen Frequenzbereichen.

Bevorzugt werden die Abtastwerte der einzelnen digitalen Signale in den zugehörigen Digital-Analog-Wandlern nicht jeweils über die gesamte Abtastperiode gehalten, sondern vielmehr nur über eine gegenüber der Abtastperiode reduzierte Zeitperiode, insbesondere über eine gegenüber der Abtastperiode deutlich reduzierte Zeitperiode, gehalten.

Auf diese Weise werden die Nullstellen der zur Treppenfunktion des Digital-Analog-Wandelns korrespondierenden Sinc-Spektralfunktion, die das Spektrum des im einzelnen Digital-Analog-Wandler jeweils erzeugten analogen Signals dämpft, jeweils in Richtung höherer Frequenzen verschoben. Diese Frequenzverschiebung der einzelnen Nullstellen der Sinc-Spektralfunktion bewirkt vorteilhaft eine geringere Dämpfung des im einzelnen Digital-Analog-Wandler jeweils erzeugten analogen Signals über einen weiteren Frequenzbereich.

Das erfindungsgemäße Verfahren und die erfindungsgemäße Vorrichtung zum Senden bzw. Empfangen von mindestens einem Hochfrequenzsignal mit paralleler und unterabgetasteter Basisbandsignalverarbeitung beziehen sich nicht nur auf das Senden bzw. Empfangen eines einzigen Hochfrequenzsignals, sondern umfassen auch das Senden bzw. Empfangen von mehreren Hochfrequenzsignalen.

Dieser Betriebsfall bezieht sich auf Mehrkanal-Übertragungssysteme mit mehreren Empfangs- und Sendekanälen(Multiple-Input-Multiple-Output(MIMO)-System; deutsch: System mit mehreren Eingängen und mehreren Ausgängen). Alternativ werden gemischte Übertragungssysteme mit abgedeckt (Single-Input-Multiple-Output(SIMO)-System; deutsch: System mit einem Eingang und mehreren Ausgängen oder Multiple-Input-Single-Output(MISO)-System; deutsch: System mit mehreren Eingängen und einem Ausgang).

Das erfindungsgemäße Verfahren und die erfindungsgemäße Vorrichtung zum Senden bzw. Empfangen von mindestens einem Hochfrequenzsignal mit paralleler und unterabgetasteter Basisbandsignalverarbeitung werden im Folgenden anhand der Zeichnung im Detail erläutert. Die Figuren der Zeichnung zeigen:

Fig. 1     eine spektrale Darstellung der Nyquist-Zonen eines digitalisierten Signals nach dem Stand der Technik,

Fig. 2A     ein Blockdiagramm einer ersten Untervariante einer ersten Ausführungsform der erfindungsgemäßen Vorrichtung zum Empfangen von mindestens einem Hochfrequenzsignal mit paralleler und unterabgetasteter Basisbandsignalverarbeitung,

Fig. 2B     ein Blockdiagramm einer zweiten Untervariante einer ersten Ausführungsform der erfindungsgemäßen Vorrichtung zum Empfangen von mindestens einem Hochfrequenzsignal mit paralleler und unterabgetasteter Basisbandsignalverarbeitung,

Fig. 3A     ein Blockdiagramm einer ersten Untervariante einer zweiten Ausführungsform der erfindungsgemäßen Vorrichtung zum Empfangen von mindestens einem Hochfrequenzsignal mit paralleler und unterabgetasteter Basisbandsignalverarbeitung,

Fig. 3B     ein Blockdiagramm einer zweiten Untervariante einer zweiten Ausführungsform der erfindungsgemäßen Vorrichtung zum Empfangen von mindestens einem Hochfrequenzsignal mit paralleler und unterabgetasteter Basisbandsignalverarbeitung,

Fig. 4     ein Flussdiagramm einer ersten Ausführungsform des erfindungsgemäßen Verfahrens zum Empfangen von mindestens einem Hochfrequenzsignal mit paralleler und unterabgetasteter Basisbandsignalverarbeitung,

Fig. 5     ein Flussdiagramm einer zweiten Ausführungsform des erfindungsgemäßen Verfahrens zum Empfangen von mindestens einem Hochfrequenzsignal mit paralleler und unterabgetasteter Basisbandsignalverarbeitung,

Fig. 6     eine spektrale Darstellung des Verlaufs der Filterfrequenzgänge der parallelen Filter der erfindungsgemäßen Vorrichtungen,

Fig. 7     ein Blockdiagramm einer erfindungsgemäßen Vorrichtung zum Senden von mindestens einem Hochfrequenzsignal mit paralleler und unterabgetasteter Basisbandsignalverarbeitung und

Fig. 8     ein Flussdiagramm eines erfindungsgemäßen Verfahrens zum Senden von mindestens einem Hochfrequenzsignal mit paralleler und unterabgetasteter Basisbandsignalverarbeitung.

Bevor die einzelnen Ausführungsformen des erfindungsgemäßen Verfahrens und der erfindungsgemäßen Vorrichtung zum Senden bzw. Empfangen von mindestens einem Hochfrequenzsignal mit paralleler und unterabgetasteter Basisbandsignalverarbeitung im Detail anhand der Figuren der Zeichnung erläutert werden, werden die für das Verständnis der Erfindung notwendigen mathematischen Grundlagen vorab vorgestellt:

Ein Hochfrequenzsignal $x(t)$ wird in einem analogen Filter i mit dessen Impulsantwort $g_{Fi}(t)$ gefaltet. Beim Filter i handelt es sich bevorzugt um ein Bandpassfilter. Alternativ kann aber auch ein Tiefpass-, ein Hochpass-, ein Allpass-Filter oder ein Filter mit beliebiger Übertragungsfunktion verwendet werden. Das zugehörige Frequenzspektrum $X(f)$ des Hochfrequenzsignals $x(t)$ ergibt nach einer Multiplikation mit der Filterübertragungsfunktion $G_{Fi}(f)$ das Frequenz-

spektrum $Y_i(f)$ des am Ausgang des Filters i anliegenden gefilterten Signals gemäß Gleichung (1).

$$Y_i(f) = G_{Fi}(f) \cdot X(f) \quad (1)$$

Nach der Analog-Digital-Wandlung und einer anschließenden diskreten Fourier-Transformation liegt ein diskretes Frequenzspektrum vor. Der Frequenzabstand $\Delta f$ der einzelnen Spektralanteile eines derartigen diskreten Frequenzspektrums entspricht dabei dem Frequenzabstand zwischen den einzelnen Trägersignalen des im Hochfrequenzsignal benutzten Mehrträgerverfahrens (DMT/OFDM), auf denen jeweils die einzelnen modulierten Daten sind.

Durch die Abtastung wiederholt sich das Spektrum des gefilterten Signals mit einer Periodizität in Höhe der Abtastfrequenz $f_A$. Unter Vernachlässigung der Verzerrung des gefilterten Signals in der Analog-Digital-Wandelung ergibt sich das Spektrum $Y_i(k \cdot \Delta f)$ eines Spektralanteils des Hochfrequenzsignals bei der Frequenz $k \cdot \Delta f$ am Ausgang des dem Filter i nachgeschalteten Analog-Digital-Wandlers gemäß Gleichung (2). In diesem Schritt findet die Unterabtastung statt. Hierbei wird vorausgesetzt, dass dieser Spektralanteil innerhalb der Durchgangsbandbreite des Filters i positioniert ist. Die Parameter $m$ und $k$ stellen ganzzahlige Laufparameter dar.

$$Y_i(k \cdot \Delta f) = \sum_{m=-\infty}^{+\infty} G_{Fi}(k \cdot \Delta f - m \cdot f_A) \cdot X(k \cdot \Delta f - m \cdot f_A) \quad (2)$$

Für ein reelles Signal $y_i(n \cdot T_A)$ ist das zugehörige Spektrum $Y_i(k \cdot \Delta f)$ gemäß Gleichung (3) konjugiert komplex symmetrisch.

$$Y_i(-k \cdot \Delta f) = Y_i^*(k \cdot \Delta f) \quad (3)$$

Wie aus Fig. 1 zu erkennen ist, weisen aufgrund der Periodizität des Spektrums in Höhe der Abtastfrequenz $f_A$ und aufgrund der konjugiert komplexen Symmetrie des Spektrums die gestrichelt dargestellten und sich periodisch fortsetzenden Bereiche des Spektrums, die eine Spektralbreite von jeweils einer halben Abtastfrequenz $f_A$ besitzen, jeweils ein identisches Spektrum auf. Äquivalent weisen auch die nicht gestrichelt dargestellten und sich periodisch fortsetzenden Bereiche des Spektrums, die ebenfalls eine Spektralbreite von jeweils einer halben Abtastfrequenz $f_A$ besitzen, jeweils ein identisches Spektrum auf.

Jeder dieser gestrichelten oder nicht gestrichelten Bereiche des Spektrums stellt jeweils eine Nyquist-Zone dar. Die Ordnung der einzelnen Nyquist-Zone erhöht sich ausgehend von der Symmetrieachse bei der Spektralfrequenz von Null.

Jede Nyquist-Zone einer ungeraden Ordnung im positiven Spektralbereich, d.h. die Nyquist-Zonen I, III und V usw. in Fig.1, und jede Nyquist-Zone einer geraden Ordnung im negativen Spektralbereich, d.h. die Nyquist-Zonen II*, IV* usw. in Fig. 1, enthält aufgrund der Identität der Spektren dieser Nyquist-Zonen nicht nur die Spektralanteile des zugehörigen eigenen analogen Spektrums, sondern auch die Spektralanteile der analogen Spektren der jeweils anderen zugeordneten Nyquist-Zonen. Äquivalent enthält jede Nyquist-Zone einer geraden Ordnung im positiven Spektralbereich, d.h. die Nyquist Zonen II, IV usw. in Fig. 1, und jede Nyquist-Zone einer ungeraden Ordnung im negativen Spektralbereich, d.h. die Nyquist-Zonen I*, III*, V* usw. in Fig. 1, aufgrund der Identität der Spektren dieser Nyquist-Zonen nicht nur die Spektralanteile des zugehörigen eigenen analogen Spektrums, sondern auch die Spektralanteile der analogen Spektren der jeweils anderen zugeordneten Nyquist-Zonen.

Somit ist es erfindungsgemäß möglich, durch eine spektrale Auswertung im Spektralbereich zwischen der negativen halben Abtastfrequenz und der positiven halben Abtastfrequenz, d.h. im Basisband des abgetasteten Signals, die Spektralanteile des Hochfrequenzsignals in den Nyquist-Zonen zu ermitteln, über die sich die Filterfrequenzgänge aller Filter erstrecken. Überdeckt das Filter mehrere Nyquist-Zonen, enthält das Basisband eine Linearkombination aller enthaltenen Nyquist-Zonen. Bei reellen Signalen muss nur die positive oder die negative Hälfte des Basisband-Spektrums betrachtet werden, da beide zueinander redundant sind.

Die Erfindung lässt sich auch auf die I- und Q-Signale am Ausgang eines IQ-Mischers übertragen. Die I- und Q-Signalpfade des IQ-Mischers werden jeweils parallel gefiltert und mittels Analog-Digital-Wandlung unterabgetastet. Die abgetasteten Werte der ADCs im I-Signalpfad werden als Realteil, die Abtastwerte der ADCs des Q-Signalpfades als Imaginärteil des Signals interpretiert. Alle weiteren Schritte in einer nachgeschalteten Entzerrungs- und Entkopplung-Einheit bleiben gleich.

Der Spektralanteil $L_i(k \cdot \Delta f)$ des digitalisierten gefilterten Signals im digitalen Basisband bei der Spektralfrequenz $k \cdot \Delta f$, in dem die Spektralanteile des digitalisierten gefilterten Signals bei der Spektralfrequenz $k \cdot \Delta f$ in allen Nyquist-Zonen des Filterfrequenzgangs des jeweiligen Filters enthalten sind, ergibt sich unter Berücksichtigung von Gleichung (3) gemäß Gleichung (4).

$$L_i(k \cdot \Delta f) = \sum_{m=-\infty}^{+\infty} G_{Fi}(k \cdot \Delta f + m \cdot f_A) \cdot X(k \cdot \Delta f + m \cdot f_A) \quad (4)$$

Typischerweise sind im Empfangssignal nur eine begrenzte Anzahl M von Nyquist-Zonen belegt. Die unendliche Summe in Gleichung (4) geht somit in eine endliche Summe gemäß Gleichung (5) über.

$$L_i(k \cdot \Delta f) = \sum_{m=-\frac{M}{2}}^{+\frac{M}{2}-1} G_{Fi}(k \cdot \Delta f + m \cdot f_A) \cdot X(k \cdot \Delta f + m \cdot f_A) \quad (5)$$

Äquivalent lässt sich Gleichung (5) auch vektoriell gemäß Gleichung (6) darstellen.

$$L_i(k \cdot \Delta f) = \left[ G_{Fi}\left(k \cdot \Delta f - \frac{M}{2} \cdot f_A\right) \quad \ldots \quad G_{Fi}\left(k \cdot \Delta f + \left(\frac{M}{2} - 1\right) \cdot f_A\right) \right] \cdot$$
$$\left[ X\left(k \cdot \Delta f - \frac{M}{2} \cdot f_A\right) \quad \ldots \quad X\left(k \cdot \Delta f + \left(\frac{M}{2} - 1\right) \cdot f_A\right) \right]^T \quad (6)$$

Die einzelnen Koeffizienten $G_{Fi}$ des ersten Vektors enthalten den Filterübertragungs-Koeffizienten des Filters $i$ bei der Spektralfrequenz $k \cdot \Delta f$ in der jeweiligen Nyquist-Zone. Soll im selben Schritt die Verzerrung durch die Senderfilter, durch den Übertragungskanal und/oder den zugehörigen Analog-Digital-Wandler entzerrt werden, so beinhaltet der Koeffizient $G_{Fi}$ in Gleichung (6) sowohl die Übertragungsfunktion des Filters i als auch die Filterfrequenzgänge der Senderfilter, die Kanalübertragungsfunktion und/oder die Übertragungsfunktion des zugehörigen Analog-Digital-Wandlers.

Äquivalent kann für die übrigen $N$ - 1 Filter eine Vektorgleichung gemäß Gleichung (6) aufgestellt werden.

Die Kombination der Vektorgleichungen aller verwendeten Filter führt zur Matrixgleichung (7).

$$\overline{L}(k \cdot \Delta f) = \tilde{F}(k \cdot \Delta f) \cdot \overline{X}(k \cdot \Delta f) \quad (7)$$

In Gleichung (7) ist sowohl die Unterabtastung sowie die Filterung durch die N Filter enthalten.

mit

$$\overline{L}(k \cdot \Delta f) = \begin{bmatrix} L_1(k \cdot \Delta f) \\ \vdots \\ L_N(k \cdot \Delta f) \end{bmatrix}$$

$$\tilde{F}(k \cdot \Delta f) = \begin{bmatrix} G_{F1}\left(k \cdot \Delta f - \frac{M}{2} \cdot f_A\right) & \ldots & G_{Fi}\left(k \cdot \Delta f + \left(\frac{M}{2} - 1\right) \cdot f_A\right) \\ \vdots & \vdots & \vdots \\ G_{FN}\left(k \cdot \Delta f - \frac{M}{2} \cdot f_A\right) & \ldots & G_{FN}\left(k \cdot \Delta f + \left(\frac{M}{2} - 1\right) \cdot f_A\right) \end{bmatrix}$$

$$\overline{X}(k \cdot \Delta f) = \left[ X\left(k \cdot \Delta f - \frac{M}{2} \cdot f_A\right) \quad \ldots \quad X\left(k \cdot \Delta f + \left(\frac{M}{2} - 1\right) \cdot f_A\right) \right]^T$$

Werden mehrere Übertragungskanäle (MIMO) verwendet vergrößert sich der Vektor $\overline{X}$ entsprechend der Anzahl der verwendeten Übertragungskanäle.

In einer ersten Variante einer Entzerrung bei einem rauscharmen Nutzsignal wird der Frequenzgang des einzelnen digitalen Entzerrungsfilters invers zum Filterfrequenzgang des jeweils vorausgehenden Filters festgelegt (sogenannter Zero-Forcing-Equalizer; deutsch ein "auf null zwingender" Entzerrer). Hierbei erhält man mittels Matrixinversion der Matrix $\tilde{F}(k \cdot \Delta f)$ und anschließender Multiplikation der inversen Matrix $\tilde{F}^{-1}(k \cdot \Delta f)$ mit dem Vektor $\overline{L}(k \cdot \Delta f)$, der die FourierTransformierten der Ausgangssignale der einzelnen Analog-Digital-Wandler bei der Spektralfrequenz $k \cdot \Delta f$ enthält,

gemäß der Matrixgleichung (8) den Schätzvektor $\hat{X}(k \cdot \Delta f)$ des Spektralanteils des Hochfrequenzsignals bei der Spektralfrequenz $k \cdot \Delta f$ innerhalb der einzelnen Nyquist-Zonen.

$$\bar{X}(k \cdot \Delta f) = \tilde{F}^{-1}(k \cdot \Delta f) \cdot \bar{L}(k \cdot \Delta f) =$$

$$\begin{bmatrix} \hat{F}_1^1(k \cdot \Delta f) & \hat{F}_1^2(k \cdot \Delta f) & \dots & \hat{F}_1^N(k \cdot \Delta f) \\ \vdots & \vdots & \vdots & \vdots \\ \hat{F}_M^1(k \cdot \Delta f) & \hat{F}_M^2(k \cdot \Delta f) & \dots & \hat{F}_M^N(k \cdot \Delta f) \end{bmatrix} \cdot$$

$$[L_1(k \cdot \Delta f) \quad L_2(k \cdot \Delta f) \dots \quad L_N(k \cdot \Delta f)]T \quad (8)$$

Die Spektralfrequenz $k \cdot \Delta f$ ist in den in Fig. 1 jeweils schraffiert dargestellten Nyquist-Zonen jeweils diejenige Spektralfrequenz, die einen Abstand in Höhe von $k \cdot \Delta f$ vom im Fig. 1 linksseitig dargestellten Rand der jeweiligen Nyquist-Zone aufweist, und in dem in Fig. 1 jeweils nicht schraffiert dargestellten Nyquist-Zonen jeweils diejenige Spektralfrequenz, die einen Abstand in Höhe von $k \cdot \Delta f$ vom in Fig. 1 rechtsseitig dargestellten Rand der jeweiligen Nyquist-Zone aufweist.

Auf diese Weise ist es möglich, im Spektralbereich die Spektralanteile des Hochfrequenzsignals jeweils auf den einzelnen Spektralfrequenzen der Träger des Hochfrequenzsignals aufeinanderfolgend zu bestimmen.

In einer zweiten Entzerrungsvariante für ein Nutzsignal mit höherem Rauschanteil werden die einzelnen Entzerrungskoeffizienten so bestimmt, dass der Rauschanteil in der Entzerrung minimiert wird. Hierzu wird beispielsweise eine Minimum-Mean-Square-Error(MMSE)-Entzerrung (deutsch: Entzerrung mittels Minimierung des mittleren Fehlerquadrats) durchgeführt. Der für die Entzerrung verwendete Ansatz kann nach dem Stand der Technik auch jeder andere Ansatz sein, welcher für die Problemstellung vorteilhaft erscheint. MMSE und ZF stellen zwei bekannte und häufig verwendete Entzerrer-Ansätze dar.

Neben einer Bestimmung der Spektralanteile des Hochfrequenzsignals auf den einzelnen Trägerfrequenzen im Spektralbereich ist grundsätzlich auch eine Bestimmung im Zeitbereich möglich.

Für die mathematische Herleitung einer technischen Lösung im Zeitbereich ist anstelle einer Multiplikation der zu den einzelnen Filtern jeweils gehörigen Filterübertragungsfunktionen mit der FourierTransformierten des Hochfrequenzsignals eine Faltung der zu den einzelnen Filtern jeweils gehörigen Impulsantworten mit dem Hochfrequenzsignal anzusetzen. Auf eine mathematische Herleitung wird in diesem Zusammenhang verzichtet.

Senderseitig werden die Informationsinhalte einer bestimmten Anzahl $N$ von digitalen Signalen $u_1(n \cdot T_A)$, $u_2(n \cdot T_A), \dots u_i(n \cdot T_A), \dots, u_N(n \cdot T_A)$ in einem zu sendenden Hochfrequenzsignal $z(t)$ übertragen. Über jeweils eine Digital-Analog-Wandlung werden korrespondierende analoge Signale $v_1(t), v_2(t), \dots, v_i(t), \dots, v_N(t)$ erzeugt.

Jeder digitale Abtastwert $u_i(n \cdot T_A)$ erzeugt einen Impuls der Form rect($t/T_A$). Der Digital-Analog-Wandler weist damit eine Übertragungsfunktion der Form sinc($f/f_A$) auf, bei der Spektralanteile oberhalb der halben Abtastfrequenz stark gedämpft werden. Durch die Verkürzung der Haltezeit auf T* < $T_A$ des Digital-Analog-Wandlers können die Nullstellen der sinc-förmigen Übertragungsfunktion zu höheren Frequenzen verschoben werden, so dass die Spektralanteile der einzelnen analogen Signale $v_1(t), v_2(t), \dots, v_i(t), \dots, v_N(t)$ über einen weiteren Frequenzbereich hinsichtlich der Amplitude unverzerrt bleiben. Eine Verkürzung der Haltezeit wird nach dem Stand der Technik beispielsweise durch Überabtastung erreicht.

In den einzelnen, den jeweiligen Digital-Analog-Wandlern jeweils nachfolgenden Filtern wird ein gefiltertes Signal $z_1(t), z_2(t), \dots, z_N(t)$ mittels Faltung des zugehörigen analogen Signals $v_1(t), v_2(t), \dots, v_N(t)$ mit einer Impulsantwort $g_{BP1}(t), g_{BP2}(t), \dots, g_{BPN}(t)$ des zugehörigen Filters gefaltet. Das Filter kann ein Bandpass-, Hochpass-, Tiefpass-, oder Allpass-Filter sowie ein Filter mit einer beliebigen Filterübertragungsfunktion sein. Dabei kann der Durchlassbereich eines Filters einen oder mehrere Nyquist-Zonen jeweils vollkommen oder teilweise überstreichen. Zu beachten ist, dass sich die FilterÜbertragungsfunktionen der einzelnen Filter voneinander unterscheiden müssen und in Summe den gesamten Spektralbereich des zu übertragenden Hochfrequenzsignals abdecken sollen.

Die Filterübertragungsfunktion $G_{BPi}(f)$ eines Bandpassfilters $i$ erstreckt sich dabei in einer möglichen Ausführungsform über den Frequenzbereich einer bestimmten Nyquist-Zone, beispielsweise über den Frequenzbereich der $i$-ten Nyquist-Zone.

Schließlich werden die einzelnen gefilterten Signale $z_1(t), z_2(t), \dots, z_N(t)$ zum Hochfrequenzsignal $z(t)$ addiert.

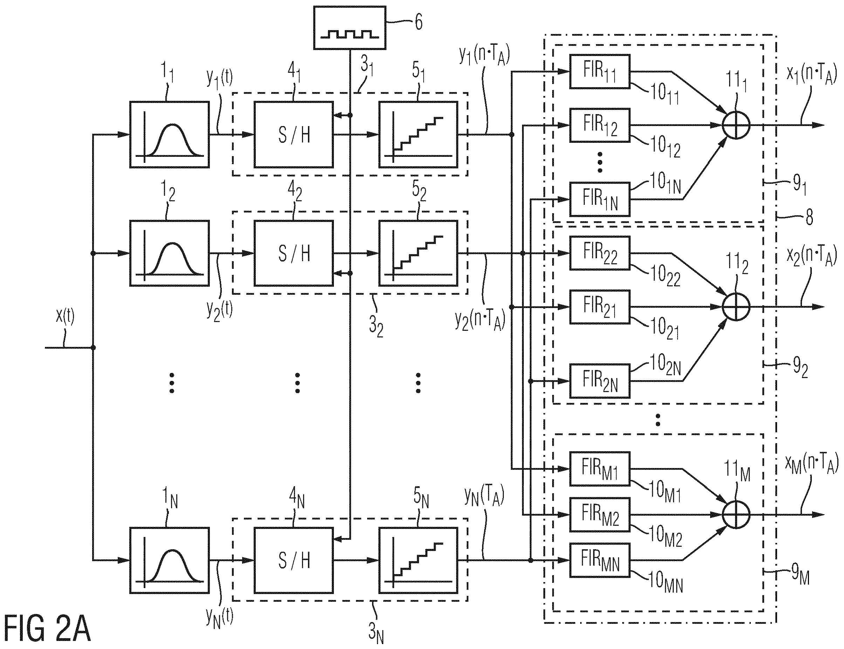

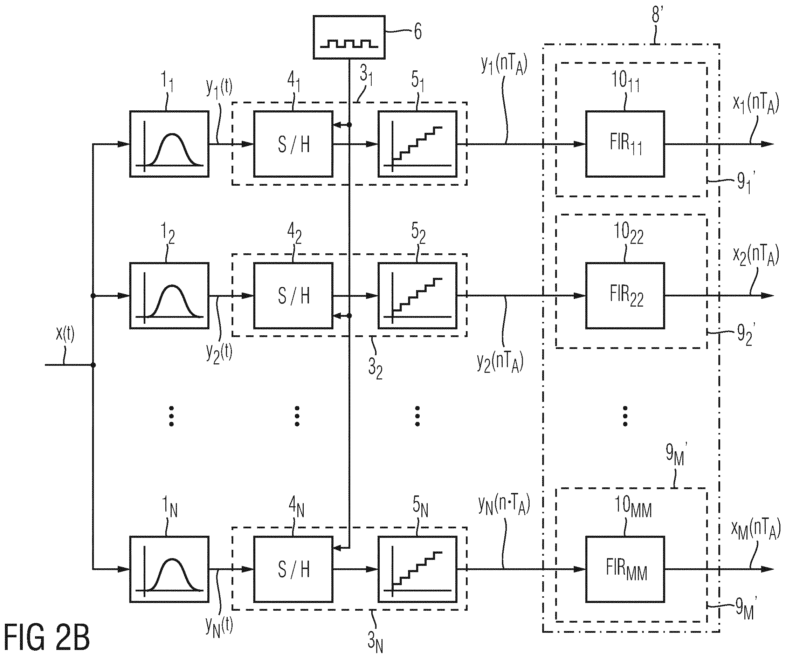

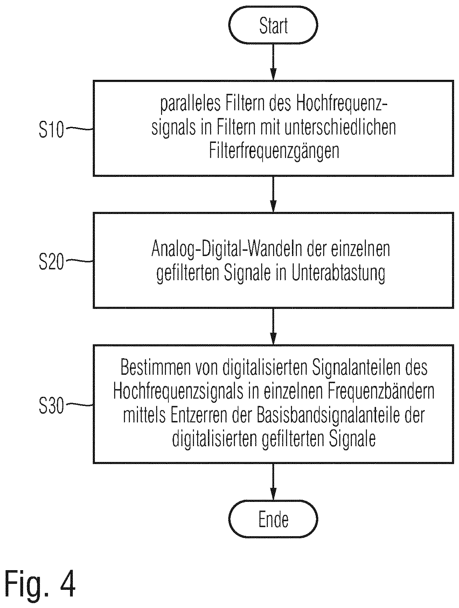

Auf der Basis der beschriebenen mathematischen Grundlagen werden im Folgenden die beiden Untervarianten der ersten Ausführungsform der erfindungsgemäßen Vorrichtung zum Empfangen von mindestens einem Hochfrequenzsignal mit paralleler und unterabgetasteter Basisbandsignalverarbeitung anhand der Blockdiagramme in den Figuren 2A und 2B in Kombination mit dem zugehörigen erfindungsgemäßen Verfahren zum Empfangen von mindestens einem Hochfrequenzsignal mit paralleler und unterabgetasteter Basisbandsignalverarbeitung anhand des Flussdiagrammes in Fig. 4 im Detail erläutert:

Im ersten Verfahrensschritt S10 wird mindestens ein Hochfrequenzsignal $x(t)$ jeweils einer bestimmten Anzahl $N$ von parallel geschalteten Filtern $1_1, 1_2, ... 1_N$ zugeführt. Die Filter $1_1, 1_2, ... 1_N$ sind jeweils analog realisiert und weisen jeweils einen unterschiedlichen Filterfrequenzgang auf. Bevorzugt handelt es sich hierbei um Bandpassfilter. Alternativ können aber auch Tiefpass-, Hochpass- oder Allpass-filter oder Filter mit einer beliebigen Filter-Übertragungsfunktion verwendet werden.

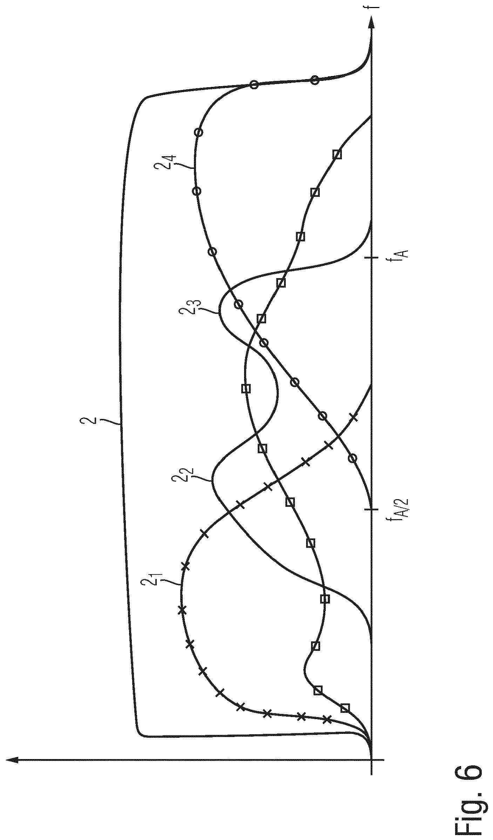

Aus Fig. 6 sind bei gegebenem Frequenzgang 2 des Hochfrequenzsignals beispielhafte Filterfrequenzgänge $2_1$, $2_2$, $2_3$ und $2_4$ von vier parallel geschalteten Bandpassfiltern dargestellt. Dabei ist zu erkennen, dass sich der Durchlassbereich einiger Filter über mehrere Nyquist-Zonen erstreckt. Zusätzlich kann der Sperrbereich eine nicht zu vernachlässigende Dämpfung aufweisen. Dadurch entstehen weitere Überlagerungen im Basisband.

Die Filterfrequenzgänge der einzelnen Filter $1_1, 1_2, .., 1_N$ decken in Kombination die in der weiteren Signalverarbeitung zu berücksichtigenden und zu untersuchenden Spektralbereiche 2 in Fig. 6 des Hochfrequenzsignals ab. Ist der gesamte Spektralbereich des Hochfrequenzsignals für die weitere Signalverarbeitung von Relevanz, so decken die Filterfrequenzgänge der einzelnen Filter $1_1, 1_2, ... 1_N$ die gesamte Bandbreite des Hochfrequenzsignals ab. Werden nur bestimmte Frequenzbänder des Hochfrequenzsignals in der weiteren Signalverarbeitung untersucht, so beschränkt sich die Kombination der Filterfrequenzgänge der einzelnen Filter $1_1, 1_2, ... 1_N$ auf die Spektralbereiche dieser Frequenzbänder.

Die Filterfrequenzgänge der einzelnen Filter $1_1, 1_2, ... 1_N$ können sich dabei jeweils vollständig, teilweise oder überhaupt nicht überdecken. Entscheidend ist, dass sie bei vollständiger oder teilweiser Überdeckung im spektralen Überdeckungsbereich jeweils einen unterschiedlichen Filterfrequenzgang aufweisen.

Im darauffolgenden Verfahrensschritt S20 werden die gefilterten Signale $y_1(t), y_2(t), ..., y_N(t)$ an den Ausgängen der einzelnen Filter $1_1, 1_2, .., 1_N$ in jeweils einem nachgeschalteten Analog-Digital-Wandler $3_1, 3_2, ..., 3_N$ in ein korrespondierendes digitalisiertes gefiltertes Signal $y_1(n \cdot T_A), y_2(n \cdot T_A), ..., y_N(n \cdot T_A)$ gewandelt. Die Analog-Digital-Wandelung erfolgt hierbei in Unterabtastung. Zur Realisierung der Unterabtastung wird der einzelne Analog-Digital-Wandler $3_1, 3_2, ..., 3_N$ bevorzugt aus einer seriellen Verschaltung eines Abtast- und Halte-Gliedes $4_1, 4_2, ..., 4_N$ (englisch: $\underline{S}$ample and $\underline{H}$old (S/H)) und eines nachgeschalteten Quantisierers $5_1, 5_2, ..., 5_N$ realisiert.

In den einzelnen Abtast- und Halte-Gliedern $4_1, 4_2, ..., 4_N$ erfolgt jeweils eine Abtastung des analog gefilterten Signals $y_1(t), y_2(t), ..., y_N(t)$ und ein Halten des jeweiligen Abtastwertes des analog gefilterten Signals $y_1(t), y_2(t), ..., y_N(t)$ über jeweils eine gleiche Abtastdauer $T_A$.

Zur Abtastung erhält jedes Abtast- und Halte-Glied $4_1, 4_2, ..., 4_N$ von einer Taktquelle 6, beispielsweise einem Taktgenerator, jeweils einen Takt mit der gleichen Abtastperiode $T_A$. Der jedem Abtast- und Halte-Glied $4_1, 4_2, ..., 4_N$ jeweils zugeführte Takt ist (phasen-)kohärent. Der den einzelnen Abtast- und Halte-Gliedern $4_1, 4_2, ..., 4_N$ jeweils zugeführte Takt ist phasenkohärent, wenn sich die Phase der einzelnen Takte jeweils zeitlich in identischer Weise ändert und sich jeweils nur in einem zeitinvarianten Phasenunterschied voneinander unterscheidet. Die Taktquelle 6 ist bevorzugt möglichst jitterarm (deutsch: schwankungsarm) zu realisieren, um eine möglichst hohe Konstanz in der Abtastfrequenz $\dfrac{1}{T_A}$ zu erzielen, da der durch Jitter (deutsch: Schwankung) verursachte Phasenfehler mit der Ordnung der Nyquist-Bänder zunimmt.

Im Quantisierer $5_1, 5_2, ..., 5_N$ erfolgt jeweils eine Amplituden-Quantisierung des abgetasteten gefilterten Signals.

Im Folgenden werden nur noch die Basisbandsignalanteile $I1(n \cdot T_A), I_2(n \cdot T_A), ..., I_N(n \cdot T_A)$ der digitalisierten gefilterten Signale $y_1(n \cdot T_A), y_2(n \cdot T_A), ..., y_N(n \cdot T_A)$ berücksichtigt. Diese Basisbandsignalanteile $I_1(n \cdot T_A), I_2(n \cdot T_A), ..., I_N(n \cdot T_A)$ der digitalisierten gefilterten Signale $y_1(n \cdot T_A), y_2(n \cdot T_A), ..., y_N(n \cdot T_A)$ enthalten jeweils überlagert sämtliche Spektralanteile des Hochfrequenzsignals $x(t)$, die innerhalb des Durchgangsbereiches des Filterfrequenzganges des jeweiligen Filters $1_1, 1_2, ... 1_N$ liegen.

Zur Separierung der in den einzelnen Nyquist-Zonen jeweils gelegenen digitalisierten Spektralanteile des Hochfrequenzsignals $x(t)$ aus den einzelnen Basisbandsignalanteilen $I_1(n \cdot T_A), I_2(n \cdot T_A), ..., I_N(n \cdot T_A)$ der digitalisierten gefilterten Signale $y1(n \cdot T_A), y_2(n \cdot T_A), ..., y_N(n \cdot T_A)$ werden die Basisbandsignalanteile $I_1(n \cdot T_A), I_2(n \cdot T_A), ..., I_N(n \cdot T_A)$ der einzelnen digitalisierten gefilterten Signale $y_1(n \cdot T_A), y_2(n \cdot T_A), ..., y_N(n \cdot T_A)$ im darauf folgenden Verfahrensschritt S30 einer Entzerrung und Entkopplung in einer Entzerrungs- und Entkopplungs-Einheit 8 zugeführt.

Diese Entzerrungs- und Entkopplungs-Einheit 8 enthält eine Anzahl $M$ von Entzerrungs- und Entkopplungs-Kanälen $9_1, 9_2, ..., 9_M$, die der in der Bandbreite des digitalisierten Hochfrequenzsignals $x(t)$ enthaltenen Anzahl $M$ von Nyquist-Zonen entspricht.

Jeder einzelne Entzerrungs- und Entkopplungs-Kanal $9_1, 9_2, ..., 9_M$ wiederum enthält eine der Anzahl $N$ von parallel geschalteten Analog-Digital Wandlern $3_1, 3_2, ..., 3_N$ entsprechende Anzahl von parallel geschalteten Entzerrungsfiltern $10_{11}, 10_{12}, ..., 10_{1N}$ bzw. $10_{21}, 10_{22}, ..., 10_{2N}$ bzw. $10_{M1}, 10_{M2}, ..., 10_{MN}$. Die Eingänge der einzelnen Entzerrungsfilter eines jeweiligen Entzerrungs- und Entkopplungs-Kanals sind jeweils mit dem Ausgang eines Analog-Digital-Wandlers $3_1, 3_2, ..., 3_N$ verbunden.

Jedes einzelne Entzerrungsfilter eines Entzerrungs- und Entkopplungs-Kanals entzerrt das jeweils zugeführte digitalisierte gefilterte Signal so, dass nach einer Summation aller Signale an den Ausgängen der zu einem Entzerrungs- und Entkopplungs-Kanal jeweils gehörigen Entzerrungsfilter ein Signal entsteht, das nur noch die Signalanteile des Hochfrequenzsignals $x(t)$ innerhalb einer zum Entzerrungs- und Entkopplungs-Kanal gehörigen Nyquist-Zone enthält. Hierbei leistet das jeweilige Entzerrungsfilter nicht nur einen Beitrag zur Entkopplung der in den einzelnen Nyquist-Zonen jeweils enthaltenen Signalanteile, sondern auch zur Entzerrung der durch den Filterfrequenzgang des jeweils vorgeschalteten Filters verursachten Verzerrung.

Daneben kann das jeweilige Entzerrungsfilter bevorzugt auch eine Entzerrung des zugeführten Signals hinsichtlich der in den einzelnen Senderfilter jeweils verursachten Verzerrung, der im Übertragungskanal verursachten Verzerrung und/oder der im jeweiligen vorgeschalteten Analog-Digital-Wandler $3_1$, $3_2$,..., $3_N$ jeweils verursachten Verzerrung zusätzlich durchführen.

Die einzelnen Entzerrungsfilter $10_{11}$, $10_{12}$, ..., $10_{1N}$, $10_{21}$, $10_{22}$, ...,$10_{2N}$,..., $10_{M1}$, $10_{M2}$, ..., $10_{MN}$ sind jeweils als digitale Filter, bevorzugt als digitale Filter mit endlicher Impulslänge (FIR-Filter) realisiert. Die Strukturierung und die Parametrisierung der einzelnen Entzerrungs-Filter erfolgt bevorzugt in einer Initialisierungsphase der erfindungsgemäßen Vorrichtung. Durch Beaufschlagung der erfindungsgemäßen Vorrichtung mit bestimmten Testsignalen und Messen der zugehörigen Antwortsignale der erfindungsgemäßen Vorrichtung werden über Optimierungsverfahren nach dem Stand der Technik die Struktur und die zugehörigen Parameter des als adaptives digitales Filter realisierten Entzerrungsfilters bestimmt. Alternativ können die Struktur und die zugehörigen Parameter der einzelnen Entzerrungsfilter auch simulationsgestützt ermittelt werden. In seltenen Ausnahmefällen ist auch eine deterministische Bestimmung von Strukturen und Parameter der einzelnen Entzerrungsfilter möglich.

In jedem einzelnen Entzerrungs- und Entkopplungs-Kanal $9_1$,$9_2$,...,$9_M$ sind die Ausgänge der zugehörigen Entzerrungsfilter mit einem gemeinsamen Summations-Glied $11_1$, $11_2$, ...,$11_M$ verbunden. Am Ausgang des jeweiligen Summations-Gliedes $11_1$, $11_2$, ...,$11_M$ liegen jeweils die Signalanteile $x_1(n \cdot T_A)$,..., $x_M(n \cdot T_A)$ des Hochfrequenzsignals $x(t)$ an, die sich in einer bestimmten vom jeweiligen Entzerrungs- und Entkopplungs-Kanal verarbeiteten Nyquist-Zone des digitalisierten Hochfrequenzsignals und sich somit in einem zur jeweiligen Nyquist-Zone gehörigen Spektralbereich des Hochfrequenzsignals befinden.

Das Hochfrequenzsignal $x(t)$ ist typischerweise als Mehrträger-Signal realisiert. Bevorzugt wird als Mehrträger-Signal ein sogenanntes DMT(Discrete Multitone Transmission)-Signal (deutsch: diskrete Mehrträger-Übertragung) verwendet. Alternativ kann das Hochfrequenzsignal $x(t)$ beispielsweise auch als OFDM (Orthogonal Frequency Division Multiplexing)-Signal (deutsch: orthogonales Frequenzbereichs-Multiplexen) realisiert sein. In Abhängigkeit der verwendeten Abtastfrequenz $\frac{1}{T_A}$ der Unterabtastung können entweder das Frequenzband eines Trägers oder die Frequenzbänder mehrerer Träger des OFDM-Signals jeweils in einer Nyquist-Zone platziert sein. Um die Orthogonalität der einzelnen Frequenzträger zu garantieren, weisen die Takte, die den einzelnen Analog-Digital-Wandlern $3_1$, $3_2$,..., $3_N$ zugeführt werden, nicht nur eine gleiche Frequenz $\frac{1}{T_A}$ des Taktes auf, sondern sind auch (phasen)kohärent zueinander auszuführen.

Neben dieser ersten Untervariante der ersten Ausführungsform der erfindungsgemäßen Vorrichtung zum Empfangen von mindestens einem Hochfrequenzsignal mit paralleler und unterabgetasteter Basisbandsignalverarbeitung gemäß Fig. 2A existiert als eine Sonderform auch eine zweite Untervariante gemäß Fig.2B:
Bei der zweiten Untervariante der ersten Ausführungsform der erfindungsgemäßen Vorrichtung zum Empfangen von mindestens einem Hochfrequenzsignal mit paralleler und unterabgetasteter Basisbandsignalverarbeitung sind die Filterfrequenzgänge der einzelnen Filter $1_1$,$1_2$,..,$1_N$ so parametriert, dass ihr jeweiliger Durchlassbereich lediglich den Spektralbereich einer einzigen Nyquist-Zone des digitalisierten Hochfrequenzsignals x(t) abdeckt.

In diesem Sonderfall vereinfacht sich die Entzerrungs-und Entkopplungs-Einheit. Die Entzerrungs- und Entkopplungs-Einheit 8' dieser zweiten Untervariante enthält in ihren einzelnen Entzerrungs- und Entkopplungs-Kanälen $9_1$', $9_2$', ...,$9_M$' jeweils nur noch ein einziges Entzerrungsfilter $10_{11}$', $10_{22}$', ...,$10_{MM}$'. Jedes dieser Entzerrungsfilter $10_{11}$', $10_{22}$', ...,$10_{MM}$' entzerrt jeweils die im vorausgehenden Filter $1_1$,$1_2$,..,$1_N$ verursachte Verzerrung. Zusätzlich kann das einzelne Entzerrungsfilter $10_{11}$', $10_{22}$', ...,$10_{MM}$', wie bereits oben bei der ersten Untervariante dargelegt ist, auch die in den einzelnen Senderfiltern jeweils verursachte Verzerrung, die im Übertragungskanal verursachte Verzerrung und/oder die im vorausgehenden Analog-Digital-Wandler $3_1$, $3_2$,..., $3_N$ jeweils verursachte Verzerrung entzerren. Ein Summations-Glied ist in den einzelnen Entzerrungs- und Entkopplungs-Kanälen $9_1$', $9_2$', ...,$9_M$' nicht erforderlich.

Die übrigen Funktionseinheiten der zweiten Untervariante der ersten Ausführungsform der erfindungsgemäßen Vorrichtung zum Empfangen von mindestens einem Hochfrequenzsignal mit paralleler und unterabgetasteter Basisbandsignalverarbeitung entsprechen der ersten Untervariante der ersten Ausführungsform und werden deshalb an dieser Stelle nicht wiederholt beschrieben. Hinsichtlich der Funktionsweise dieser Funktionseinheiten wird auf die zugehörige Beschreibung zur ersten Untervariante der ersten Ausführungsform verwiesen. Dasselbe gilt für die zweite Untervariante der ersten Ausführungsform des erfindungsgemäßen Verfahrens zum Empfangen von mindestens einem Hochfrequenzsignal mit paralleler und unterabgetasteter Basisbandsignalverarbeitung.

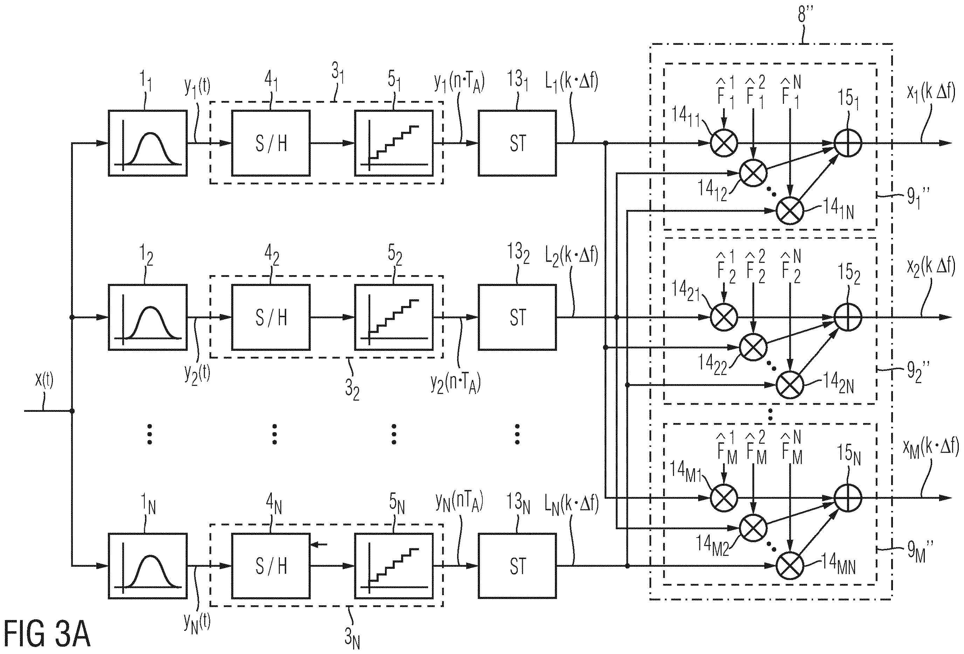

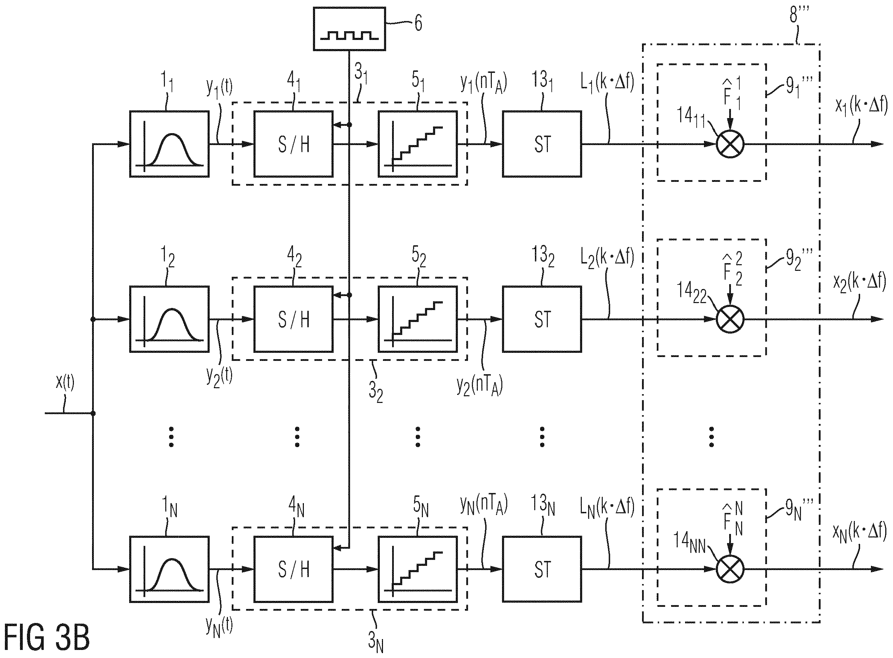

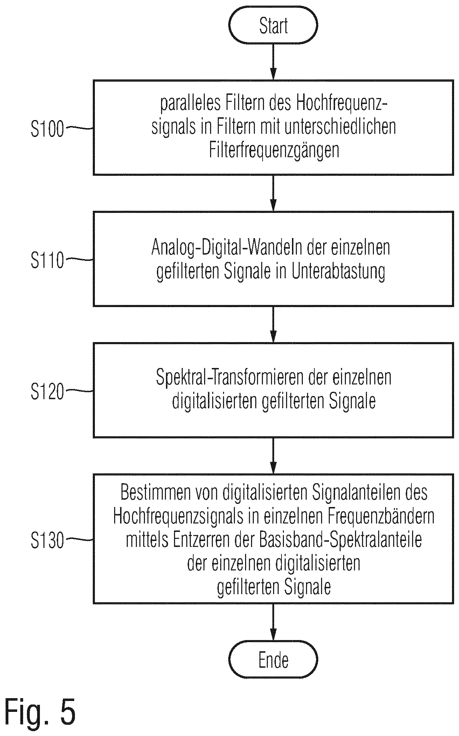

Im Folgenden werden die beiden Untervarianten der zweiten Ausführungsform der erfindungsgemäßen Vorrichtung zum Empfangen von mindestens einem Hochfrequenzsignal mit paralleler und unterabgetasteter Basisbandsignalverarbeitung anhand der Blockdiagramme in den Figuren 3A und 3B in Kombination mit dem zugehörigen erfindungsgemäßen Verfahren zum Empfangen von mindestens einem Hochfrequenzsignal mit paralleler und unterabgetasteter Basisbandsignalverarbeitung anhand des Flussdiagrammes in Fig. 5 im Detail erläutert:

Die ersten beiden Verfahrensschritte S100 und S110 der zweiten Ausführungsform des erfindungsgemäßen Verfahrens zum Empfangen von mindestens einem Hochfrequenzsignal mit paralleler und unterabgetasteter Basisbandsignalverarbeitung entsprechen den ersten beiden Verfahrensschritten S10 und S20 der ersten Ausführungsform des erfindungsgemäßen Verfahrens. Selbiges gilt für die zugehörigen Funktionseinheiten der zweiten Ausführungsform der erfindungsgemäßen Vorrichtung zum Empfangen von mindestens einem Hochfrequenzsignal mit paralleler und unterabgetasteter Basisbandsignalverarbeitung. Somit wird an dieser Stelle auf das wiederholte Beschreiben verzichtet und auf die zugehörigen Ausführungen zur ersten Ausführungsform obig verwiesen.

Falls als Übertragungsverfahren DMT oder OFDM verwendet wird, wird im Verfahrensschritt S210 dem jeweiligen Analog-Digital-Wandler $3_1$, $3_2$,..., $3_N$ jeweils ein optionales, in Fig. 3A nicht dargestelltes Filter zur Verkürzung der Kanalimpulsantwort sowie eine Einheit zum Entfernen des Guardintervalls (deutsch: Schutz-Intervall) nachgeschaltet. Schlussendlich transformiert ein Spektral-Transformator (ST) $13_1$, $13_2$,...,$13_N$ das digitalisierte gefilterte Signal $y_1(n \cdot T_A), y_2(n \cdot T_A),...,y_N(n \cdot T_A)$ in das jeweils zugehörige diskrete Spektrum $Y_1(k \cdot \Delta f), Y_2(k \cdot \Delta f),...,Y_N(k \cdot \Delta f)$. Dieser Schritt wird bevorzugt mittels eines Fourier-Transformators, beispielsweise mittels eines Fast-Fourier-Transformators (FFT) (deutsch: schneller Fourier-Transformator) oder mittels eines diskreten Fourier-Transformators (DFT), durchgeführt.

Im Folgenden und abschließenden Verfahrensschritt S130 werden nur die Basisband-Spektralanteile $L_1(k \cdot \Delta f), L_2(k \cdot \Delta f),...,L_N(k \cdot \Delta f)$, der digitalisierten Spektren $Y_1(k \cdot \Delta f), Y_2(k \cdot \Delta f),...,Y_N(k \cdot \Delta f)$ in einer nachfolgenden Verzerrungs- und Entkopplungs-Einheit 8' berücksichtigt.

Hierbei werden einerseits die in den Basisband-Spektralanteilen $L_1(k \cdot \Delta f), L_2(k \cdot \Delta f), ...,L_N(k \cdot \Delta f)$ der einzelnen digitalisierten Spektren $Y_1(k \cdot \Delta f), Y_2(k \cdot \Delta f),..., Y_N(k \cdot \Delta f)$ jeweils enthaltenen und zu den einzelnen Nyquist-Zonen des digitalisierten Hochfrequenzsignals jeweils gehörigen Spektralanteile entkoppelt und zu den Spektralanteilen des digitalisierten Hochfrequenzsignals zusammengefügt, die jeweils zu einer der Nyquist-Zonen des digitalisierten Hochfrequenzsignals gehören. Andererseits wird die Verzerrung durch die Filterfrequenzgänge der einzelnen Filter $1_1, 1_2,..,1_N$, die in den einzelnen Basisband-Spektralanteilen $L_1(k \cdot \Delta f), L_2(k \cdot \Delta f),...,L_N(k \cdot \Delta f)$ der einzelnen digitalisierten Spektren $Y_1(k \cdot \Delta f), Y_2(k \cdot \Delta f),..., Y_N(k \cdot \Delta f)$ steckt, entzerrt. Zusätzlich ist in Analogie zur ersten Ausführungsform auch eine Entzerrung der in den einzelnen Senderfiltern jeweils verursachten Verzerrung, der vom Übertragungskanal verursachten Verzerrung und/oder der durch das Übertragungsverhalten der Analog-Digital-Wandler $3_1$, $3_2$,..., $3_N$ und der nachgeschalteten Fourier-Transformatoren $13_1$, $13_2$,..., $13_N$ jeweils verursachten Verzerrungen in der Entzerrungs- und Entkopplungs-Einheit 8'' realisierbar.

Die Entzerrungs- und Entkopplungs-Einheit 8'' setzt sich wiederum aus einer der Anzahl *M* von Nyquist-Zonen innerhalb der Bandbreite des digitalisierten Hochfrequenzsignals entsprechenden Anzahl von parallel geschalteten Entzerrungs- und Entkopplungs-Kanälen $9_1''$, $9_2''$,...,$9_M''$ zusammen.

Jeder Entzerrungs- und Entkopplungs-Kanal $9_1''$, $9_2''$,...,$9_M''$ weist eine der Anzahl *N* von parallel geschalteten Analog-Digital-Wandlern $3_1$, $3_2$,..., $3_N$ entsprechende Anzahl von parallelen Multiplizier-Gliedern $14_{11}$, $14_{12}$,..., $14_{1N}$ bzw. $14_{21}$, $14_{22}$,..., $14_{2N}$ bzw. $14_{M1}$, $14_{M2}$,..., $14_{MN}$ auf.

In jedem Entzerrungs- und Entkopplungs-Kanal $9_1''$, $9_2''$,...,$9_M''$ ist jeweils eine der in der Bandbreite des digitalisierten Hochfrequenzsignals enthaltenen Anzahl N von Nyquist-Zonen entsprechende Anzahl von Multiplizier-Gliedern $14_{11}$, $14_{12}$, ..., $14_{1N}$ bzw. $14_{21}$, $14_{22}$, ..., $14_{2N}$ bzw. $14_{M1}$, $14_{M2}$, ..., $14_{MN}$ vorhanden. Der Eingang jedes Multiplizier-Gliedes eines Entzerrungs- und Entkopplungs-Kanals $9_1''$, $9_2''$,...,$9_M''$ ist jeweils mit dem Ausgang eines zugehörigen Fourier-Transformators $13_1$, $13_2$,..., $13_N$ verbunden.

Jedes einzelne Multiplizier-Glied eines Entzerrungs- und Entkopplungs-Kanals entzerrt das jeweils zugeführte diskrete Spektrum des zugehörigen digitalisierten gefilterten Signals so, dass nach einer Summation aller diskreten Spektren an den Ausgängen der zu einem Entzerrungs- und Entkopplungs-Kanal jeweils gehörigen Multiplizierglieder ein Spektrum entsteht, das nur noch die Spektralanteile des Hochfrequenzsignals x(t) innerhalb einer zum Entzerrungs- und Entkopplungs-Kanal jeweils gehörigen Nyquist-Zone enthält. Hierzu multipliziert jedes Multiplizier-Glied 14ij (mit $i \in \{1 ... M\}$ und $j \in \{1 ... N\}$) für jede Spektralfrequenz $k \cdot \Delta f$ jeweils den Basisband-Spektralanteil $L_j(k \cdot \Delta f)$ des jeweiligen Spektrums $Y_j(k \cdot \Delta f)$ mit dem zugehörigen spektralen Entzerrungskoeffizienten $\hat{F}_i^j(k \cdot \Delta f)$, der beispielsweise gemäß Gleichung (8) berechnet wird.

Die Ausgänge aller Multiplizier-Glieder eines Entzerrungs- und Entkopplungs-Kanals $9_1''$, $9_2''$,..., $9_M''$ sind mit den Eingängen eines zum jeweiligen Entzerrungs-und Entkopplungs-Kanal $9_1''$, $9_2''$,...,$9_M''$ jeweils gehörigen Summa-

tions-Gliedes $15_1$, $15_2$, ..., $15_M$ verbunden. Das Summations-Glied $15_1$, $15_2$, ..., $15_M$ eines jeweiligen Entzerrungs- und Entkopplungs-Kanals $9_1''$, $9_2''$,...,$9_M''$ liefert an seinem Ausgang jeweils sämtliche digitalisierten Spektralanteile $X_1(k \cdot \Delta f)$,...,$X_M(k \cdot \Delta f)$ des Hochfrequenzsignals innerhalb der zum jeweiligen Entzerrungs- und Entkopplungs-Kanal $9_1''$, $9_2''$,...,$9_M''$ jeweils gehörigen Nyquist-Zone und somit innerhalb des zur jeweiligen Nyquist-Zone gehörigen Spektralbereichs des Hochfrequenzsignals.

Bei der zweiten Untervariante der zweiten Ausführungsform der erfindungsgemäßen Vorrichtung zum Empfangen von mindestens einem Hochfrequenzsignal mit paralleler und unterabgetasteter Basisbandsignalverarbeitung gemäß Fig. 3B entspricht der Durchlassspektralbereich der zu den einzelnen Filtern $1_1$,$1_2$,...,$1_N$ jeweils gehörigen Filterfrequenzgänge jeweils nur einer einzigen Nyquist-Zone des digitalisierten Hochfrequenzsignals. In diesem Fall reduziert sich der einzelne Entzerrungs- und Entkopplungs-Kanal $9_1''$, $9_2''$,...,$9_M''$ jeweils auf ein einziges Multiplizier Glied $14_{11}$, $14_{22}$, ..., $14_{NN}$.

In jedem Multiplizier Glied $14_{11}$, $14_{22}$, ..., $14_{NN}$ wird jeweils für jede Spektralfrequenz $k \cdot \Delta f$ jeweils der Basisband-Spektralanteil $L_1(k \cdot \Delta f)$,$L_2(k \cdot \Delta f)$, ...,$L_N(k \cdot \Delta f)$ des jeweils zugeführten digitalisierten Spektrums $Y_1(k \cdot \Delta f)$, $Y_2(k \cdot \Delta f)$,..., $Y_N(k \cdot \Delta f)$ mit den zugehörigen spektralen Entzerrungskoeffizienten $\hat{F}_1^1(k \cdot \Delta f), \ \hat{F}_2^2(k \cdot \Delta f), \ ..., \hat{F}_N^N(k \cdot \Delta f)$ multipliziert. Da die Anzahl der parallel geschalteten Analog-Digital Wandler $3_1$, $3_2$,...,$3_N$ in diesem Sonderfall der zweiten Untervariante der Anzahl von Nyquist-Zonen innerhalb der Bandbreite des digitalisierten Hochfrequenzsignals entspricht, gilt $N$ = $M$ und damit $\hat{F}_N^N(k \cdot \Delta f) = \hat{F}_M^M(k \cdot \Delta f)$.

Die spektralen Entzerrungskoeffizienten $\hat{F}_1^1(k \cdot \Delta f), \hat{F}_2^2(k \cdot \Delta f), ..., \hat{F}_N^N(k \cdot \Delta f)$ bei den einzelnen Spektralfrequenzen $k \cdot \Delta f$ ergeben sich bei der ersten Entzerrer-Variante beispielsweise jeweils aus dem inversen Filterfrequenzgang des jeweils vorgeschalteten Filters $1_1$,$1_2$,...,$1_N$ bei denselben Spektralfrequenzen $k \cdot \Delta f$.

An den Ausgängen der einzelnen Multiplizier-Glieder $14_{11}$, $14_{22}$, ..., $14_{NN}$, die gleichzeitig auch die Ausgänge der Entzerrungs- und Entkopplungs-Einheit $8'''$ darstellen, liegen somit jeweils die digitalisierten Spektralanteile $X_1(k \cdot \Delta f)$, ...,$X_N(k \cdot \Delta f)$ des Hochfrequenzsignals in den einzelnen Nyquist-Zonen und somit in den einzelnen Spektralbereichen der zum digitalisierten Hochfrequenzsignal gehörigen Nyquist-Zonen an.

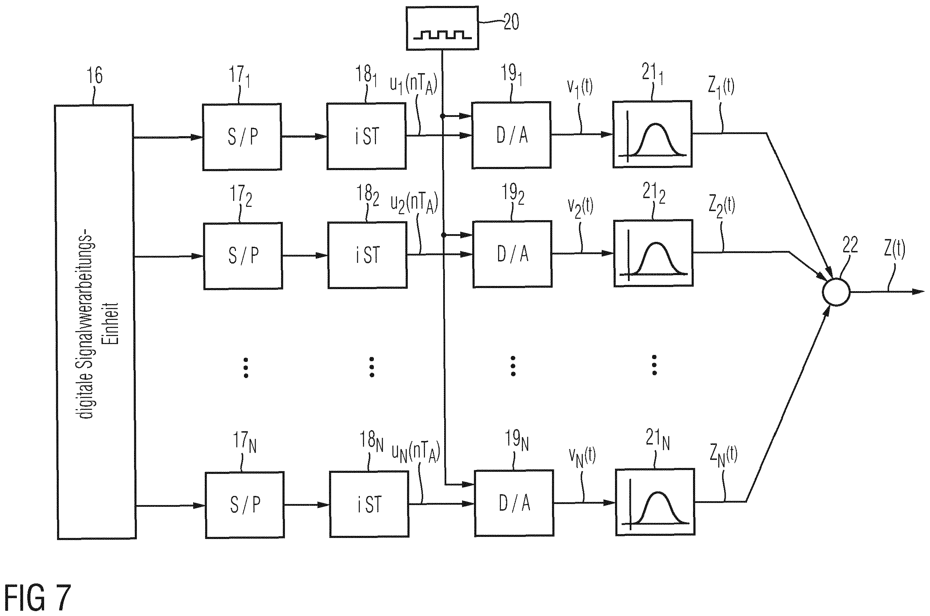

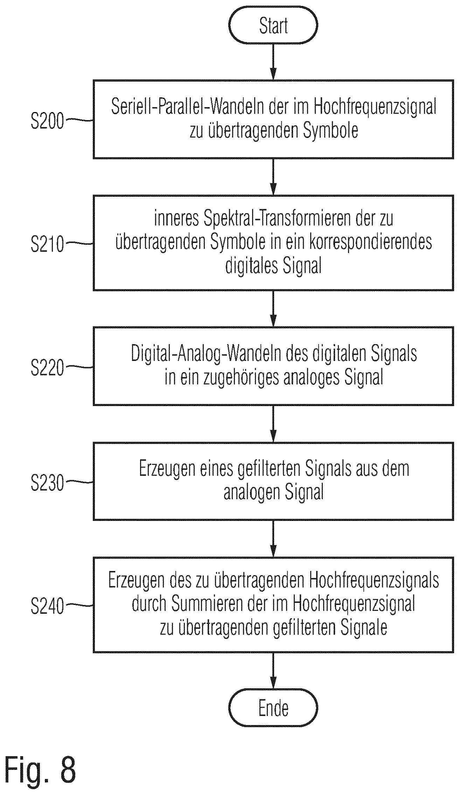

Schließlich wird die erfindungsgemäße Vorrichtung zum Senden von mindestens einem Hochfrequenzsignal mit paralleler und unterabgetasteter Basisbandsignalverarbeitung anhand des Blockdiagramms in Fig. 7 in Kombination mit dem erfindungsgemäßen Verfahren zum Senden von mindestens einem Hochfrequenzsignal mit paralleler und unterabgetasteter Basisbandsignalverarbeitung anhand des Flussdiagramms in Fig. 8 im Folgenden im Detail erläutert: Wird für die Übertragung ein Mehrträgersystem (DMT/OFDM) verwendet, so werden im ersten Verfahrensschritt S200 die im Spektralbereich vorliegenden Symbole aller in einem Hochfrequenzsignal $z(t)$ jeweils zu übertragenden digitalen Basisbandsignale $u_1(n \cdot T_A)$,$u_2(n \cdot T_A)$,...,$u_N(n \cdot T_A)$ aus einem internen Speicher einer digitalen Signalverarbeitungseinheit 16 gelesen. Bei den im Spektralbereich vorliegenden Symbolen kann es sich beispielsweise um OFDM- oder DMT-Symbole handeln.

Die seriell ausgelesenen Symbole jedes einzelnen digitalen Signals $u_1(n \cdot T_A)$,$u_2(n \cdot T_A)$,..., $u_N(n \cdot T_A)$ werden im selben Verfahrensschritt S200 in einer zugehörigen Einheit zum Seriell-Parallel-Wandeln $17_1$, $17_2$,..., $17_N$ in einzelnen Einheiten von jeweils parallelen Symbolen gewandelt. Die Anzahl von parallelen Symbolen entspricht der Spektral-Länge der der einzelnen Einheit zum Seriell-Parallel-Wandeln $17_1$,$17_2$,...,$17_N$ jeweils nachfolgenden inversen Spektral-Transformatoren (iST) $18_1$,$18_2$,...,$18_N$. Bei den inversen Spektral-Transformatoren $18_1$,$18_2$,...,$18_N$ handelt es sich bevorzugt jeweils um einen inversen Fourier-Transformator, der beispielsweise ein inverser Fast-Fourier-Transformator (iFFT) oder ein inverser diskreter Fourier-Transformator (iDFT) sein kann.

In den einzelnen inversen Spektral-Transformatoren $18_1$,$18_2$,...,$18_N$ werden die zu jeweils einem digitalen Signal $u_1(n \cdot T_A)$,$u_2(n \cdot T_A)$,...,$u_N(n \cdot T_A)$ jeweils gehörigen Einheiten von parallelen Symbolen im nächsten Verfahrensschritt S210 sukzessive in zugehörige Einheiten von parallelen Abtastwerten der digitalen Signale $u_1(n \cdot T_A)$, $u_2(n \cdot T_A)$,..., $u_N(n \cdot T_A)$ gewandelt.

Schließlich wird im selben Verfahrensschritt S210 noch ein Guardintervall in jeweils einer in Fig. 7 nicht dargestellten Einheit zum Einfügen eines Guard-Intervalls hinzugefügt.

Die Funktionen des Seriell-Parallel-Wandelns, des inversen Spektral-Transformierens und des Einfügens eines Guard-Intervalls werden vorzugsweise bereits in der digitalen Signalverarbeitungseinheit 16 durchgeführt.

Im darauffolgenden Verfahrensschritt S220 werden die zu den einzelnen digitalen Signalen $u_1(n \cdot T_A)$,$u_2(n \cdot T_A)$,..., $u_N(n \cdot T_A)$ jeweils gehörigen Abtastwerte sukzessive einem dem zugehörigen inversen Spektral-Transformator $18_1$,$18_2$,...,$18_N$ jeweils nachfolgenden Digital-Analog-Wandler $19_1$,$19_2$,...,$19_N$ zugeführt und in ein zugehöriges analoges Signal $v_1(t)$,$v_2(t)$,...,$v_N(t)$ gewandelt.

Soll anstelle von DMT/OFDM ein anderes Übertragungsverfahren verwendet werden, werden die digitalen

Basisbanddaten $u_1(n \cdot T_A), u_2(n \cdot T_A),..., u_N(n \cdot T_A)$ im Verfahrensschritt S220 dem Digital-Analog-Wandler $19_1, 19_2,..., 19_N$ zugeführt und in ein zugehörigen analoges Signal $v_1(t), v_2(t),..., v_N(t)$ gewandelt.

Hierbei ist festzustellen, dass die Abtastwerte der einzelnen digitalen Signale $u_1(n \cdot T_A), u_2(n \cdot T_A),..., u_N(n \cdot T_A)$ an den Eingängen der einzelnen Digital-Analog-Wandler $19_1, 19_2,..., 19_N$ in den vorausgehenden Verarbeitungsstufen im Basisband vorliegen müssen, d.h. in einer Abtastrate vorliegen, die kleiner, insbesondere deutlich kleiner, als die doppelte höchste im zugehörigen analogen Signal $v_1(t), v_2(t),..., v_N(t)$ jeweils vorliegende Spektralfrequenz ist.

Die Taktung der einzelnen Digital-Analog-Wandler $19_1, 19_2,..., 19_N$ erfolgt hierbei durch einen gemeinsamen

Takt $\dfrac{1}{T_A}$, der von einer gemeinsamen Taktquelle 20 geliefert wird.

Die Abtastwerte der einzelnen digitalen Signale $u_1(n \cdot T_A), u_2(n \cdot T_A),..., u_N(n \cdot T_A)$ werden in den einzelnen Digital-Analog-Wandlern $19_1, 19_2,..., 19_N$ bevorzugt nicht über die gesamte Abtastperiode $T_A$, sondern lediglich über eine gegenüber der Abtastperiode $T_A$ deutlich reduzierte Abtastperiode $T_A^*$ gehalten.

In den an die einzelnen Digital-Analog-Wandler $19_1, 19_2,..., 19_N$ sich jeweils anschließenden Filtern $21_1, 21_2, 21_N$ werden im darauffolgenden Verfahrensschritt S230 die Spektralanteile des jeweiligen analogen Signal $v_1(t), v_2(t),..., v_N(t)$ gefiltert, die im Wesentlichen im Durchgangsbereich des zum jeweiligen Filter $21_1, 21_2,..., 21_N$ gehörigen Filterfrequenzganges liegen. Die Filterfrequenzgänge der einzelnen Filter $21_1, 21_2,..., 21_N$ unterscheiden sich voneinander und decken in Summe den gesamten Spektralbereich des zu sendenden Hochfrequenzsignals z(t) ab. Die Filterfrequenzgänge jedes einzelnen Filter $21_1, 21_2,..., 21_N$ können sich jeweils über eine Nyquist-Zone oder mehrere Nyquist-Zonen jeweils vollständig oder teilweise erstrecken. Am Ausgang jedes einzelnen Filters $21_1, 21_2,..., 21_N$ liegt jeweils ein gefiltertes Signal $z_1(t), z_2(t),..., z_N(t)$ an.

In einem Sonderfall werden in jedem einzelnen Filter $21_1, 21_2,..., 21_N$ jeweils nur die Spektralanteile im Frequenzbereich einer jeweils unterschiedlichen Nyquist-Zone gefiltert, die dem jeweiligen analogen Signal $v_1(t), v_2(t),..., v_N(t)$ jeweils zugewiesen wird. In dem beschriebene Fall enthalten die als Bandpasssignale ausgeführten gefilterten Signale $z_1(t), z_2(t),..., z_N(t)$ an den Ausgängen der einzelnen als Bandpassfilter realisierten Filter $21_1, 21_2,..., 21_N$ folglich jeweils nur noch die Spektralanteile einer einzigen und jeweils voneinander unterschiedlichen Nyquist-Zone.

Im abschließenden Verfahrensschritt S240 werden die Signale $z_1(t), z_2(t),..., z_N(t)$ in einem den Filtern $21_1, 21_2, 21_N$ nachfolgenden Summationsglied 22 zu einem zu sendenden Hochfrequenzsignal $z(t)$ addiert. Während das im Empfänger empfangene Hochfrequenzsignal x(t) mit Störungen des Übertragungskanals überlagert und verzerrt ist, ist das im Sender zu sendende Hochfrequenzsignal z(t) frei von Störungen des Übertragungskanals.

Erfindungsgemäß sind im zu sendenden Hochfrequenzsignal $z(t)$ die in den einzelnen digitalen Signalen $u_1(n \cdot T_A), u_2(n \cdot T_A),..., u_N(n \cdot T_A)$ jeweils enthaltenen bzw. übertragenen Informationen ohne Durchführung eines Mischens ins Hochfrequenzband enthalten.

Ein weiterer wesentlicher technischer Vorteil des erfindungsgemäßen Verfahrens und der erfindungsgemäßen Vorrichtung liegt darin, dass die technische Struktur an die technischen Gegebenheiten des zu verarbeitenden Hochfrequenzsignals und an die Genauigkeit bei der Erfassung und Weiterverarbeitung bzw. bei der Erzeugung des Hochfrequenzsignals anpassbar und damit skalierbar ist. Somit ist es möglich, die Anzahl der parallelen Analog-Digital-Wandler bzw. der parallelen Digital-Analog-Wandler einerseits an die Bandbreite des Hochfrequenzsignals bzw. an die zu untersuchenden Spektralbereiche des Hochfrequenzsignals als auch an die benutzte Abtastfrequenz der Unterabtastung anzupassen.

## Patentansprüche

1. Verfahren zum Empfangen von mindestens einem Hochfrequenzsignal ,x(t), mit paralleler und unterabgetasteter Basisbandsignalverarbeitung mit folgenden Verfahrensschritten:

• Erzeugen von mehreren gefilterten Signalen ,$y_1(t), y_2(t),..., y_N(t)$, durch paralleles Filtern des jeweiligen Hochfrequenzsignals ,x(t),, wobei jedes einzelne Filtern jeweils mittels eines unterschiedlichen Filterfrequenzganges erfolgt,
• Erzeugen eines zu jedem gefilterten Signal ,$y_1(t), y_2(t),..., y_N(t)$, jeweils gehörigen digitalisierten gefilterten Signals ,$y_1(n \cdot T_A), y2(n \cdot T_A),..., y_N(n \cdot T_A)$, durch Analog-Digital-Wandeln des jeweiligen gefilterten Signals ,$y_1(t), y_2(t),..., y_N(t)$,, wobei jedes Analog-Digital-Wandeln jeweils mittels Unterabtastung erfolgt,
• Ermitteln von Signalanteilen ,$x1(n \cdot T_A),..., x_M(n \cdot T_A)$; $X_1(k \cdot \Delta f),..., X_M(k \cdot \Delta f)$, des jeweiligen Hochfrequenzsignals ,x(t), im digitalen Basisband mittels Entzerren von Basisbandsignalanteilen ,$l_1(n \cdot T_A), l_2(n \cdot T_A),..., l_N(n \cdot T_A)$; $L_1(k \cdot \Delta f), L_2(k \cdot \Delta f), L_N(k \cdot \Delta f)$, der zugehö-

rigen digitalisierten gefilterten Signale $,y_1(t),y_2(t),...,y_N(t),$

**dadurch gekennzeichnet,**
**dass** das Ermitteln von zu jedem digitalisierten gefilterten Signal $,y_1(n \cdot T_A),y_2(n \cdot T_A),...,y_N(n \cdot T_A),$ jeweils gehörigen Basisbandsignalanteilen jeweils ein Ermitteln eines Fourier-Spektrums $,Y_1(k \cdot \Delta f),Y_2(k \cdot \Delta f),...,Y_N(k \cdot \Delta f),$ des jeweiligen digitalisierten gefilterten Signals $,y_1(n \cdot T_A),y2(n \cdot TA),...,y_N(n \cdot T_A),$ mittels Fourier-Transformieren und ein Weiterverfolgen von einzig im Basisbandspektrum enthaltenen Fourier-Spektralanteilen des jeweiligen Fourier-Spektrums $,Y_1(k \cdot \Delta f),Y_2(k \cdot \Delta f),...,Y_N(k \cdot \Delta f),$ ist und

das Entzerren von Basisbandsignalanteilen der einzelnen digitalisierten gefilterten Signale $,y_1(n \cdot T_A),y_2(n \cdot T_A),...y_N(n \cdot T_A),$ ein Multiplizieren der einzig im Basisbandspektrum enthaltenen Fourier-Spektralanteile des jeweiligen Fourier-Spektrums $,Y_1(k \cdot \Delta f),Y_2(k \cdot \Delta f), ...,Y_N(k \cdot \Delta f),$ mit zugehörigen spektralen Entzerrungskoeffizienten

$$,\hat{F}_1^1(k \cdot \Delta f), \hat{F}_1^2(k \cdot \Delta f), ..., \hat{F}_1^N(k \cdot \Delta f),..., \hat{F}_M^1(k \cdot \Delta f), \hat{F}_M^2(k \cdot \Delta f),..., \hat{F}_M^N(k \cdot \Delta f),$$ ist,

wobei das Hochfrequenzsignal $,x(t),$ ein Discrete-Multi-Tone-Signal oder ein Orthogonal-Frequency-Division-Multiplexing-Signal ist und
wobei das Discrete-Multi-Tone-Signal oder das Orthogonal-Frequency-Division-Multiplexing-Signal Träger aufweist, die in einer Nyquist-Zone einer ungeraden Ordnung einen Frequenzabstand $,k \cdot \Delta f,$ zu einem unteren Rand der Nyquist-Zone und in einer Nyquist-Zone einer geraden Ordnung einen Frequenzabstand $,k \cdot \Delta f,$ zu einem oberen Rand der Nyquist-Zone aufweisen, wobei $,k,$ ein ganzzahliger Laufparameter und $,\Delta f,$ ein Frequenzabstand zwischen zwei benachbarten Trägern ist.

2. Verfahren nach Patentanspruch 1,
**dadurch gekennzeichnet,**
**dass** das Analog-Digital-Wandeln aller gefilterten Signale $,y_1(t),y_2(t),...,y_N(t),$ mit einer gleichen Abtastfrequenz

$,\dfrac{1}{T_A},$ erfolgt.

3. Verfahren nach Patentanspruch 2,
**dadurch gekennzeichnet,**
**dass** jedes Analog-Digital-Wandeln aller gefilterten Signale kohärent $,y_1(t),y_2(t),...,y_N(t),$ erfolgt.

4. Verfahren nach einem der Patentansprüche 1 bis 3,
**dadurch gekennzeichnet,**
**dass** das Entzerren Verzerrungen beim Filtern, beim Analog-Digital-Wandeln, bei einem Übertragen des jeweiligen Hochfrequenzsignals in einem Übertragungskanal und/oder bei einem Erzeugen des jeweiligen Hochfrequenzsignals berücksichtigt.

5. Verfahren nach einem der Patentansprüche 1 bis 4,
**dadurch gekennzeichnet,**
**dass** sich die Filterfrequenzgänge des parallelen Filterns sich jeweils über mehrere Nyquist-Zonen erstrecken.

6. Verfahren nach einem der Patentansprüche 1 bis 5,
**dadurch gekennzeichnet,**
**dass** die Filterfrequenzgänge des parallelen Filterns sich vollständig oder teilweise überdecken.

7. Verfahren zum Senden von mindestens einem Hochfrequenzsignal $,z(t),$ mit paralleler und unterabgetasteter Basisbandsignalverarbeitung mit folgenden Verfahrensschritten für jedes einzelne Hochfrequenzsignal $,z(t),$:

    • Erzeugen von analogen Signalen $,v_1(t),v_2(t),...,v_N(t),$ mittels Digital-Analog-Wandeln eines jeweils zugehörigen digitalen Signals $,u_1(n \cdot T_A) u_2(n \cdot T_A),...,u_N(n \cdot T_A),$ wobei jedes digitale Signal $,u_1(n \cdot T_A),u_2(n \cdot T_A),...,u_N(n \cdot T_A),$ im Basisband vorliegt, und wobei die Abtastrate der einzelnen digitalen Signale kleiner als die doppelte höchste Spektralfrequenz im zugehörigen analogen Signal ist,
    • Erzeugen von Signalen $,z_1(t),z_2(t),...,z_N(t),$ mittels Filtern jedes zugehörigen analogen Signals $,v_1(t),v_2(t),...,v_N(t),,$ wobei jedes einzelne Filtern jeweils mittels eines unterschiedlichen Filterfrequenzganges erfolgt, und

• Erzeugen des Hochfrequenzsignals ,$y(t)$, mittels Summieren aller Filtersignale ,$z_1(t),z_2(t),...,z_N(t)$, wobei das Hochfrequenzsignal ,$y(t)$, ein Discrete-Multi-Tone-Signal oder ein Orthogonal-Frequency-Division-Multiplexing-Signal ist und

wobei das Discrete-Multi-Tone-Signal oder das Orthogonal-Frequency-Division-Multiplexing-Signal Träger aufweist, die in einer Nyquist-Zone einer ungeraden Ordnung einen Frequenzabstand ,$k \cdot \Delta f$, zu einem unteren Rand der Nyquist-Zone und in einer Nyquist-Zone einer geraden Ordnung einen Frequenzabstand ,$k \cdot \Delta f$, zu einem oberen Rand der Nyquist-Zone aufweisen, wobei ,$k$, ein ganzzahliger Laufparameter und ,$\Delta f$, ein Frequenzabstand zwischen zwei benachbarten Trägern ist.

8. Verfahren nach Patentanspruch 7,
**dadurch gekennzeichnet,**
**dass** jedes digitale Signal ,$u_1(nk \cdot T_A),u_2(n \cdot T_A),...,u_N(n \cdot T_A)$, beim Digital-Analog-Wandeln jeweils nur über eine gegenüber der Abtastperiode ,$T_A$, des digitalen Signals ,$u_1(n \cdot T_A),u_2(n \cdot T_A),...,u_N(n \cdot T_A)$, reduzierte Zeitdauer ,$T_A^*$, gehalten wird.

9. Verfahren nach Patentanspruch 7 oder 8,
**dadurch gekennzeichnet,**
**dass** die Frequenzgänge des parallelen Filterns sich vollständig oder teilweise überdecken.

10. Verfahren nach einem der Patentansprüche 7 bis 9,
**dadurch gekennzeichnet,**
**dass** sich die Frequenzgänge des parallelen Filterns über mehrere Nyquist-Zonen erstrecken.

11. Vorrichtung zum Empfangen von mindestens einem Hochfrequenzsignal ,$x(t)$, mit paralleler und unterabgetasteter Basisbandsignalverarbeitung umfassend jeweils mehrere parallel geschaltete Filter ($1_1,1_2,..,1_N$) zum Erzeugen von jeweils einem gefilterten Signal ,$y_1(t),y_2(t),...,y_N(t)$,, an deren Eingängen jeweils das jeweilige Hochfrequenzsignal ,$x(t)$, anliegt und deren Filterfrequenzgänge sich jeweils voneinander unterscheiden, einen jedem Filter ($1_1,1_2,..,1_N$) jeweils nachgeschalteten Analog-Digital-Wandler ($3_1,3_2,...,3_N$) zum Erzeugen von jeweils einem digitalisierten gefilterten Signal ,$y_1(n \cdot T_A),y_2(n \cdot T_A),...,y_N(n \cdot T_A)$,, wobei in jedem Analog-Digital-Wandler ($3_1,3_2,...,3_N$) jeweils eine Abtastung mit einer Unterabtastung erfolgt, und eine den Analog-Digital-Wandlern ($3_1,3_2,...,3_N$) jeweils nachgeschaltete Entzerrungs- und Entkopplungs-Einheit ($8; 8'; 8''; 8'''$),
**dadurch gekennzeichnet,**
**dass** zwischen jedem Analog-Digital-Wandler ($3_1,3_2,...,3_N$) und der Entzerrungs- und Entkopplungs- Einheit ($8''; 8'''$) jeweils ein Fourier-Transformator ($13_1,13_2,..., 13_N$) zum Erzeugen eines zum jeweiligen digitalisierten gefilterten Signal ,$y_1(n \cdot T_A),y_2(n \cdot T_A),...,y_N(n \cdot T_A)$, jeweils gehörigen Spektrums ,$Y_1(k \cdot \Delta f),Y_2(k \cdot \Delta f),Y_N(k \cdot \Delta f)$,vorgeschaltet ist und die Entzerrungs- und Entkopplungs-Einheit ($8; 8'; 8''; 8'''$) mindestens eine der Anzahl ,$N$, von gefilterten Signalen ,$y_1(t),y_2(t),...,y_N(t)$, entsprechende Anzahl ,$N$, von Multiplizier-Gliedern ($14_{11},14_{12},...,14_{1N},..,14_{21}, 14_{22},..., 14_{2N},..., 14_{M1},14_{M2},...,14_{MN}$) enthält,
wobei das Hochfrequenzsignal ,$x(t)$, ein Discrete-Multi-Tone-Signal oder ein Orthogonal-Frequency-Division-Multiplexing-Signal ist und
wobei das Discrete-Multi-Tone-Signal oder das Orthogonal-Frequency-Division-Multiplexing-Signal Träger aufweist, die in einer Nyquist-Zone einer ungeraden Ordnung einen Frequenzabstand ,$k \cdot \Delta f$, zu einem unteren Rand der Nyquist-Zone und in einer Nyquist-Zone einer geraden Ordnung einen Frequenzabstand ,$k \cdot \Delta f$, zu einem oberen Rand der Nyquist-Zone aufweisen, wobei ,$k$, ein ganzzahliger Laufparameter und $\Delta f$, ein Frequenzabstand zwischen zwei benachbarten Trägern ist.

12. Vorrichtung nach Patentanspruch 11,
**dadurch gekennzeichnet,**
**dass** die Filterfrequenzgänge aller Filter ($1_1, 1_2, ..,1_N$) zusammen das gesamte Frequenzspektrum des Hochfrequenzsignals ,$x(t)$, abdecken.

13. Vorrichtung nach Patentanspruch 11 oder 12,
**dadurch gekennzeichnet,**
**dass** jeder Analog-Digital-Wandler ($3_1, 3_2,...,3_N$) mit einer gleichen Taktquelle (6) verbunden ist.

**14.** Vorrichtung nach einem der Patentansprüche 11 bis 13,
**dadurch gekennzeichnet,**
**dass** die Entzerrungs- und Entkopplungs-Einheit (8; 8'; 8''; 8''') mindestens eine der Anzahl ,N, von gefilterten Signalen ,$y_1(t),y_2(t),y_N(t)$, entsprechende Anzahl ,N, von Entzerrungsfiltern ($10_{11},10_{12},...,10_{1N}...,10_{21},10_{22},...,10_{2N}...,\ 10_{M1},10_{M2},...,10_{MN}$) enthält.

**15.** Vorrichtung zum Senden von mindestens einem Hochfrequenzsignal ,$z(t)$, mit paralleler und unterabgetasteter Basisbandsignalverarbeitung umfassend jeweils eine Anzahl von Digital-Analog-Wandlern ($19_1,19_2,...,19_N$) zur Erzeugung von jeweils einem analogen Signal ,$v_1(t),v_2(t),...,v_N(t)$, aus einem zugehörigen digitalen Basisbandsignal ,$u_1(n \cdot T_A),u_2(n \cdot T_A),...,u_N(n \cdot T_A)$,, wobei die Anzahl , N, von Digital-Analog-Wandlern ($19_1,19_2,...,19_N$) der Anzahl von im jeweiligen Hochfrequenzsignal ,$z(t)$, jeweils zu übertragenden digitalen Basisbandsignale ,$u_1(n \cdot T_A),u_2(n \cdot T_A),...,u_N(n \cdot T_A)$, entspricht, und wobei die Abtastrate der einzelnen digitalen Basisbandsignale kleiner als die doppelte höchste Spektralfrequenz im zugehörigen analogen Signal ist, ein jedem Digital-Analog-Wandler ($19_1,19_2,...,19_N$) jeweils nachgeschaltetes Filter ($21_1,21_2,\ ...,21_N$) zur Erzeugung von jeweils einem zugehörigen gefilterten Signal ,$z_1(t),z_2(t),...,z_N(t)$,, wobei der Filterfrequenzgang der Filter ($21_1,21_2,...,21_N$) sich in Summe über alle relevanten Nyquist-Zonen erstreckt, und ein den Filtern ($21_1,21_2,...,21_N$) jeweils nachgeschalteten Summations-Glied (22) zur Erzeugung des jeweiligen Hochfrequenzsignals ,$z(t)$,
wobei das Hochfrequenzsignal ,$y(t)$, ein Discrete-Multi-Tone-Signal oder ein Orthogonal-Frequency-Division-Multiplexing-Signal ist und wobei das Discrete-Multi-Tone-Signal oder das Orthogonal-Frequency-Division-Multiplexing-Signal Träger aufweist, die in einer Nyquist-Zone einer ungeraden Ordnung einen Frequenzabstand ,$k \cdot \Delta f$, zu einem unteren Rand der Nyquist-Zone und in einer Nyquist-Zone einer geraden Ordnung einen Frequenzabstand ,$k \cdot \Delta f$, zu einem oberen Rand der Nyquist-Zone aufweisen, wobei ,$k$, ein ganzzahliger Laufparameter und ,$\Delta f$, ein Frequenzabstand zwischen zwei benachbarten Trägern ist.

**16.** Vorrichtung nach Patentanspruch 15,
**dadurch gekennzeichnet,**
**dass** jeder Digital-Analog-Wandler ($19_1,19_2,...,19_N$) mit einer gleichen Taktquelle (20) verbunden ist.

**17.** System zum Übertragen von mindestens einem Hochfrequenzsignal mit paralleler und unterabgetasteter Basisbandsignalverarbeitung mit einer Vorrichtung zum Empfangen von mindestens einem Hochfrequenzsignal mit paralleler und unterabgetasteter Basisbandsignalverarbeitung nach einem der Patentansprüche 11 bis 14, einer Vorrichtung zum Senden von mindestens einem Hochfrequenzsignal mit paralleler und unterabgetasteter Basisbandsignalverarbeitung nach Patentanspruch 15 oder 16 und einem zwischen der Vorrichtung zum Senden und der Vorrichtung zum Empfangen befindlichen Übertragungskanal.

**Claims**

**1.** A method for receiving at least one high-frequency signal, **x(t),** having parallel and under-sampled baseband signal processing with the following method steps:

• Generation of a plurality of filtered signals, **$y_1(t)$, $y_2(t)$, ..., $y_N(t)$,** by parallel filtering of the respective high-frequency signal, **x(t),** wherein each individual filtering is performed by means of a different filter frequency response,
• generation of a digitized filtered signal, **$y_1(n \cdot T_A)$, $y_2(n \cdot T_A)$, ..., $y_N(n \cdot T_A)$,** associated in each case with each filtered signal, **$y_1(t)$, $y_2(t)$, ..., $y(t)$,** by analog-digital conversion of the respective filtered signal, **$y_1(t)$, $y_2(t)$, ..., $y_N(t)$,** wherein each analog-digital conversion is performed in each case by under-sampling,
• determination of signal components $x_1(n \cdot T_A)$, ..., $x_M(n \cdot T_A)$; $X_1(k \cdot \Delta f)$, ..., $X_M(k \cdot \Delta f)$ of the high-frequency signal, x(t), in the digital baseband by equalizing the baseband signal components, **$I_1(n \cdot T_A)$, $I_2(n \cdot T_A)$, ..., $I_N(n \cdot T_A)$; $L_1(k \cdot \Delta f)$, $L_2(k \cdot \Delta f)$, ..., $L_N(k \cdot \Delta f)$** of the associated digitized filtered signals **$y_1(t)$, $y_2(t)$, ..., $y_N(t)$,**

**characterized in**
**that** the determination of baseband signal components in each case associated with each digitized filtered signal **$y_1(n \cdot T_A)$, $y_2(n \cdot T_A)$, ..., $y_N(n \cdot T_A)$** in each case is a determination of a Fourier spectrum **$Y_1(k \cdot \Delta f)$, $Y_2(k \cdot \Delta f)$, ..., $Y_N(k \cdot \Delta f)$,** of the respective digitized filtered signal **$y_1(n \cdot T_A)$, $y_2(n \cdot T_A)$, ..., $y_N(n \cdot T_A)$,** by means of Fourier transforming and a further tracking of the Fourier spectral components of the respective Fourier spectrum **$Y_1(k \cdot \Delta f)$, $Y_2(k \cdot \Delta f)$, ..., $Y_N(k \cdot \Delta f)$** only contained in the baseband spectrum, and the equalizing of baseband signal components of the individual

digitized filtered signals $y_1(n \cdot T_A)$, $y_2(n \cdot T_A)$, ..., $y_N(n \cdot T_A)$, a multiplication of the Fourier spectral components of the respective Fourier spectrum $Y_1(k \cdot \Delta f)$, $Y_2(k \cdot \Delta f)$, ...,$Y_N(k \cdot \Delta f)$ contained only in the baseband spectrum, with associated spectral equalization coefficients,

$$\hat{F}_1^1(k \cdot \Delta f), \hat{F}_1^2(k \cdot \Delta f), ..., \hat{F}_1^N(k \cdot \Delta f), .., \hat{F}_M^1(k \cdot \Delta f), \hat{F}_M^2(k \cdot \Delta f), ..., \hat{F}_M^N(k \cdot \Delta f),$$

wherein the high frequency signal, x(t), is a discrete multi-tone signal or an orthogonal frequency-division multiplexing signal and

wherein the discrete multi-tone signal or the orthogonal frequency-division multiplexing signal has carriers, which in a Nyquist zone of an odd ordering has a frequency spacing, $k \cdot \Delta f$, from a lower edge of the Nyquist zone and in a Nyquist zone of an even ordering has a frequency spacing, $k \cdot \Delta f$, from an upper edge of the Nyquist zone, wherein, k, is an integer running parameter and, $\Delta f$, is a frequency spacing between two adjacent carriers.

2. The method according to patent claim 1,
   **characterized in**
   **that** the analog-digital conversion of all filtered signals, $y_1(t)$, $y_2(t)$, ..., $y_N(t)$, takes place with a same sampling frequency, $\dfrac{1}{TA}$.

3. The method according to patent claim 2,
   **characterized in**
   **that** each analog-digital conversion of all filtered signals, $y_1(t)$, $y_2(t)$, ..., $y_N(t)$, takes place coherently.

4. The method according to any one of patent claims 1 to 3,
   **characterized in**
   **that** the equalization takes into account distortions during the filtering, during the analog-digital conversion, during a transmission of the respective high frequency signal in a transmission channel and/or during a generation of the respective high frequency signal.

5. The method according to any one of patent claims 1 to 4,
   **characterized in**
   **that** the filter frequency responses of the parallel filtering extend in each case over a plurality of Nyquist zones.

6. The method according to any one of patent claims 1 to 5,
   **characterized in**
   **that** the filter frequency responses of the parallel filtering overlap completely or partially.

7. The method for sending at least one high frequency signal, **z(t),** having parallel or under-sampled baseband signal processing with the following method steps for each individual high frequency signal, **z(t),:**

   • Generation of analog signals, $v_1(t)$, $v_2(t)$, ..., $v_N(t)$, by means of digital-analog conversion of an in each case associated digital signal, $u_1(n \cdot T_A)$, $u_2(n \cdot T_A)$, ..., $u_N(n \cdot T_A)$, wherein each digital signal, $u1(n \cdot T_A)$, $u_2(n \cdot T_A)$, ..., $u_N(n \cdot T_A)$, is present in the baseband, and wherein the sampling rate of the individual digital signals is less than twice the highest spectral frequency in the associated analog signal,
   • generation of signals, $z_1(t)$, $z_2(t)$, ..., $z_N(t)$, by means of filtering each associated analog signal $v_1(t)$, $v_2(t)$, ..., $v_N(t)$, wherein each individual filtering takes place in each case by means of a different filter frequency response, and
   • generation of the high frequency signal, **y(t),** by means of summing all filter signals, $z_1(t)$, $z_2(t)$, ..., $z_N(t)$,

   wherein
   the high frequency signal, **y(t)** is a discrete multi-tone signal or an orthogonal frequency-division multiplexing signal and
   wherein
   the discrete multi-tone signal or the orthogonal frequency-division multiplexing signal has carriers, which in a Nyquist zone of an odd ordering has a frequency spacing, $k \cdot \Delta f$, from a lower edge of the Nyquist zone and in a Nyquist zone of an even ordering has a frequency spacing, $k \cdot \Delta f$, from an upper edge of the Nyquist zone, wherein, **k,** is an integer running parameter and, $\Delta$**f,** is a frequency spacing between two adjacent carriers.

8. The method according to patent claim 7,
**characterized in**
**that** each digital signal, $u_1(n \cdot T_A)$, $u_2(n \cdot T_A)$, ..., $u_N(n \cdot T_A)$, during the digital-analog conversion is held only over a reduced time period. $T_A^*$ , relative to the sampling periods, $T_A$, of the digital signal $u_1(n \cdot T_A)$, $u_2(n \cdot T_A)$, ..., $u_N(n \cdot T_A)$.

9. The method according to any one of patent claims 7 to 8,
**characterized in**
**that** the frequency responses of the parallel filtering completely or partially overlap.

10. The method according to any one of patent claims 7 to 9,
**characterized in**
**that** the frequency responses of the parallel filtering extend over a plurality of Nyquist zones.

11. A device for receiving at least one high frequency signal, **x(t),** having parallel and under-sampled baseband signal processing comprising in each case a plurality of filters $(1_1, 1_2, ..., 1_N)$ connected in parallel for generating in each case a filtered signal $y_1(t)$, $y_2(t)$, ..., $y_N(t)$, at the inputs of which in each case the respective high frequency signal, **x(t),** is applied and the filter frequency responses of which in each case differ from one another, an analog-digital converter $(3_1, 3_2, ..., 3_N)$ in each case connected downstream of each filter $(1_1, 1_2, .., 1_N)$ for generating in each case a digitized filtered signal, $y_1(n \cdot T_A)$, $y_2(n \cdot T_A)$, ..., $y_N(n \cdot T_A)$, wherein in each analog-digital converter $(3_1, 3_2, ..., 3_N)$ in each case a sampling with an under-sampling takes place and an equalizing and decoupling unit (8; 8'; 8"; 8''') in each case connected downstream of the analog-digital converters $(3_1, 3_2, ..., 3_N)$,
**characterized in**
**that** between each analog-digital converter $(3_1, 3_2, ..., 3_N)$ and the equalizing and decoupling unit (8; 8'; 8"; 8''') in each case a Fourier transformer $(13_1, 13_2, ..., 13_N)$ is connected upstream for the generation of a spectrum $Y_1(k \cdot \Delta f)$, $Y_2(k \cdot \Delta f)$,..., $Y_N(k \cdot \Delta f)$ in each case associated with the respective digitized filtered signal, $y_1(n \cdot T_A)$, $y_2(n \cdot T_A)$, ..., $y_N(n \cdot T_A)$, and the equalizing and decoupling unit (8; 8'; 8"; 8''') contains at least one number, **N,** of multiplier elements $(14_{11}, 14_{12}, ..., 14_{1N}, ..., 14_{21}, 14_{22}, ..., 14_{2N}, ..., 14_{M1}, 14_{M2}, ..., 14_{MN})$ corresponding to the number, **N,** of filtered signals $y_1(t)$, $y_2(t)$, ..., $y_N(t)$,
wherein the high frequency signal, **x(t),** is a discrete multi-tone signal or an orthogonal frequency-division multiplexing signal and
wherein the discrete multi-tone signal or the orthogonal frequency-division multiplexing signal has carriers, which in a Nyquist zone of an odd ordering has a frequency spacing, **k** $\cdot \Delta$**f,** from a lower edge of the Nyquist zone and in a Nyquist zone of an even ordering has a frequency spacing, **k** $\cdot \Delta$**f,** from an upper edge of the Nyquist zone, wherein, **k,** is an integer running parameter and, $\Delta$**f,** is a frequency spacing between two adjacent carriers.

12. The device according to patent claim 11,
**characterized in**
**that** the filter frequency responses of all filters $(1_1, 1_2, ..., 1_N)$ together cover the entire frequency spectrum of the high frequency signal, **x(t).**

13. The device according to patent claim 11 or 12,
**characterized in**
**that** each analog-digital converter $(3_1, 3_2, ..., 3_N)$ is connected to a same clock source (6).

14. The device according to any one of patent claims 11 to 13,
**characterized in**
**that** the equalizing and decoupling unit (8; 8'; 8"; 8''') contains at least one number, **N,** of equalizing filters $(10_{11}, 10_{12}, ..., 10_{1N}, ..., 1021, 1022, ..., 102N, ..., 10_{M1}, 10_{M2}, ..., 10_{MN})$ corresponding to the number, N, of filtered signals, $y_1(t)$, $y_2(t)$, ..., $y_N(t)$.

15. The device for sending at least one high frequency signal, **z(t),** having parallel or under-sampled baseband signal processing comprising in each case a number of digital-analog converters $(19_1, 19_2, ..., 19_N)$ for the generation of in each case an analog signal $v_1(t)$, $v_2(t)$, ..., $v_N(t)$, from an associated digital baseband signal , $u_1(n \cdot T_A)$, $u_2(n \cdot$

$T_A$), ..., $u_N(n \cdot T_A)$, wherein the number, **N,** corresponds to the number of digital baseband signals $u_1(n \cdot T_A)$, $u_2(n \cdot T_A)$, ..., $u_N(n \cdot T_A)$, to be transmitted in each case in the respective high frequency signal, z(t), and wherein the sampling rate of the individual digital baseband signals is less than twice the highest spectral frequency in the associated analog signal, a filter ($21_1$, $21_2$, ..., $21_N$) connected in each case downstream of each digital-analog converter ($19_1$, $19_2$, ..., $19_N$) for the generation of in each case an associated filtered signal **$z_1(t)$, $z_2(t)$, ..., $z_N(t)$,** wherein the filter frequency response of the filter ($21_1$, $21_2$, ..., $21_N$) extends in sum over all relevant Nyquist zones, and a summation element (22) connected downstream in each case of the filters ($21_1$, $21_2$, ..., $21_N$) for the generation of the respective high frequency signal, **z(t),**

wherein

the high frequency signal, **y(t),** is a discrete multi-tone signal or an orthogonal frequency-division multiplexing signal and

wherein

the discrete multi-tone signal or the orthogonal frequency-division multiplexing signal has carriers, which in a Nyquist zone of an odd ordering has a frequency spacing, **k · Δf,** from a lower edge of the Nyquist zone and in a Nyquist zone of an even ordering has a frequency spacing, **k · Δf,** from an upper edge of the Nyquist zone, wherein, k, is an integer running parameter and, **Δf,** is a frequency spacing between two adjacent carriers.

**16.** The device according to patent claim 15,
**characterized in**
**that** each digital-analog converter ($19_1$, $19_2$, ..., $19_N$) is connected to a same clock source (20).

**17.** A system for the transmission of at least one high frequency signal having parallel and under-sampled baseband signal processing with a device for receiving at least one high frequency signal having parallel and under-sampled baseband signal processing according to any one of patent claims 11 to 14, with a device for sending at least one high frequency signal having parallel and under-sampled baseband signal processing according to patent claim 15 or 16 and with a transmission channel located between the device for sending and the device for receiving.

**Revendications**

**1.** Procédé de réception d'au moins un signal à haute fréquence x(t), avec un traitement de signal de bande de base parallèle et sous-échantillonné, avec les étapes suivantes :

• production de plusieurs signaux filtrés $y_1(t)$, $y_2(t)$...$y_N(t)$, par filtrage parallèle du signal à haute fréquence x(t) correspondant, chaque filtrage individuel étant effectue au moyen d'une réponse en fréquence de filtrage différente,
• production d'un signal filtré numérisé $y_1(n.T_A)$, $y_2(n.T_A)$...$y_N(n.T_A)$, correspondant respectivement à chaque signal filtré $y_1(t)$, $y_2(t)$...$y_N(t)$, par conversion analogique-numérique du signal filtré $y_1(t)$, $y_2(t)$...$y_N(t)$ correspondant, chaque conversion analogique-numérique étant effectuée respectivement par sous-échantillonnage,
• détermination de composantes de signal $x_1(n.T_A)$...$x_M(n.T_A)$ ; $X_1(k.\Delta f)$...$X_M(k.\Delta f)$ du signal à haute fréquence correspondant x(t) dans la bande de base numérique par égalisation des composantes des signaux de bande de base $I_1(n.T_A)$, $I_2(n.T_A)$...$I_N(n.T_A)$ ; $L_1(k.\Delta f)$, $L_2(k.\Delta f)$... $L_N(k.\Delta f)$ des signaux filtrés numérisés correspondants $y_1(t)$, $y_2(t)$... $y_N(t)$

**caractérisé en ce que**
la détermination des composantes du signal de bande de base correspondant respectivement à chaque signal filtré numérisé $y_1(n.T_A)$, $y_2(n.T_A)$...$y_N(n.T_A)$ étant une détermination d'un spectre de Fourier $Y_1(k.\Delta f)$, $Y_2(k.\Delta f)$... $Y_N(k.\Delta f)$ du signal filtré numérisé $y_1(n.T_A)$, $y_2(n.T_A)$...$y_N(n.T_A)$ correspondant au moyen d'une transformation de Fourier et un suivi de composantes spectrales de Fourier contenues de manière unique dans le spectre de bande de base du spectre de Fourier $Y_1(k.\Delta f)$, $Y_2(k.\Delta f)$ ... $Y_N(k.\Delta f)$ respectif et l'égalisation des composantes du signal de bande de base des différents signaux filtrés numérisés $y_1(n.T_A)$, $y_2(n.T_A)$...$y_N(n.T_A)$ étant une multiplication des composantes spectrales de Fourier contenues de manière unique dans le spectre de bande de base du spectre de Fourier $Y_1(k.\Delta f)$, $Y_2(k.\Delta f)$ ... $Y_N(k.\Delta f)$ avec des coefficients d'égalisation spectraux correspondants

$$\hat{F}_1^1(k \cdot \Delta f), \hat{F}_1^2(k \cdot \Delta f), ..., \hat{F}_1^N(k \cdot \Delta f), ..., \hat{F}_M^1(k \cdot \Delta f), \hat{F}_M^2(k \cdot \Delta f), ..., \hat{F}_M^N(k \cdot \Delta f),$$

le signal à haute fréquence x(t) étant un signal Discrete-Multi-Tone ou un signal Orthogonal-Frequency-Division-Multiplexing et

le signal Discrete-Multi-Tone ou le signal Orthogonal-Frequency-Division-Multiplexing comprenant des porteuses qui présentent, dans une zone de Nyquist d'ordre impair, une distance de fréquence $k.\Delta f$ par rapport à un bord inférieur de la zone de Nyquist et, dans une zone de Nyquist d'ordre pair, distance de fréquence $k.\Delta f$ par rapport à un bord supérieur de la zone de Nyquist, k étant un paramètre variable entier et $\Delta f$ étant une distance de fréquence entre deux porteuses adjacentes.

2. Procédé selon la revendication 1,
**caractérisé en ce que**
la conversion analogique-numérique de tous les signaux filtrés $y_1(t)$, $y_2(t)$... $y_N(t)$ a lieu avec une même fréquence de balayage $1/T_A$.

3. Procédé selon la revendication 2,
**caractérisé en ce que**
chaque conversion analogique-numérique de tous les signaux filtrés $y_1(t)$, $y_2(t)$... $y_N(t)$ a lieu de manière cohérente.

4. Procédé selon l'une des revendications 1 à 3,
**caractérisé en ce que**
l'égalisation prend en compte les distorsions lors du filtrage, lors de la conversion analogique-numérique, lors d'une transmission du signal à haute fréquence correspondant dans un canal de transmission et/ou lors d'une production du signal à haute fréquence correspondant.

5. Procédé selon l'une des revendications 1 à 4,
**caractérisé en ce que**
les réponses en fréquence de filtrage du filtrage parallèle s'étendent respectivement sur plusieurs zones de Nyquist.

6. Procédé selon l'une des revendications 1 à 5,
**caractérisé en ce que**
les réponses en fréquence de filtrage du filtrage parallèle se recouvrent entièrement ou partiellement.

7. Procédé d'émission d'au moins un signal à haute fréquence z(t), avec un traitement du signal de bande de base parallèle et sous-échantillonné, avec les étapes suivantes pour chaque signal à haute fréquence individuel z(t) :

• production de signaux analogiques $v_1(t)$, $v_2(t)$...$v_N(t)$, au moyen d'une conversion numérique-analogique d'un signal numérique $u_1(n.T_A)$, $u_2(n.T_A)$... $u_N(n.T_A)$, chaque signal numérique $u_1(n.T_A)$, $u_2(n.TA)$...$u_N(n.T_A)$ se trouvant dans la bande de base et la fréquence de balayage des différents signaux numériques étant inférieures au double de fréquence spectrale la plus élevée dans le signal analogique correspondant,
• production de signaux $z_1(t)$, $z_2(t)$... $z_N(t)$ au moyen du filtrage de chaque signal analogique $v_1(t)$, $v_2(t)$... $v_N(t)$ correspondant, chaque filtrage étant effectué respectivement au moyen d'une réponse en fréquence différente et
• production du signal à haute fréquence y(t) par addition de tous les signaux filtrés $z_1(t)$, $z_2(t)$... $z_N(t)$, le signal à haute fréquence y(t) étant un signal Discrete-Multi-Tone ou un signal Orthogonal-Frequency-Division-Multiplexing et le signal Discrete-Multi-Tone ou le signal Orthogonal-Frequency-Division-Multiplexing comprenant des porteuses qui présentent, dans une zone de Nyquist d'ordre impair, une distance de fréquence $k.\Delta f$ par rapport à un bord inférieur de la zone de Nyquist et, dans une zone de Nyquist d'ordre pair, distance de fréquence $k.\Delta f$ par rapport à un bord supérieur de la zone de Nyquist, k étant un paramètre variable entier et $\Delta f$ étant une distance de fréquence entre deux porteuses adjacentes.

8. Procédé selon la revendication 7
**caractérisé en ce que**
chaque signal numérique $u_1(n.T_A)$, $u_2(n.TA)$...$u_N(n.T_A)$ est maintenu, lors de la conversion numérique-analogique, respectivement seulement sur une durée $T_A^*$ réduite par rapport à la période de balayage $T_A$ du signal numérique $u_1(n.T_A)$, $u_2(n.T_A)$... $u_N(n.T_A)$.

9. Procédé selon la revendication 7 ou 8
**caractérisé en ce que**
les réponses en fréquence du filtrage parallèle se recouvrent entièrement ou partiellement.

10. Procédé selon l'une des revendications 7 à 9
**caractérisé en ce que**

les réponses en fréquence du filtrage parallèle s'étendent sur plusieurs zones de Nyquist.

11. Dispositif pour la réception d'au moins un signal à haute fréquence x(t) avec un traitement de signal de bande de base parallèle et sous-échantillonnée, comprenant respectivement plusieurs filtres branchés en parallèle ($1_1$, $1_2$...$1_N$), pour la production respectivement d'un signal filtré $y_1(t)$, $y_2(t)$...$y_N(t)$, au niveau des entrées desquels le signal à haute fréquence respectif x(t) est appliqué et dont les réponses en fréquence de filtrage sont différentes entre elles, un convertisseur analogique-numérique ($3_1$, $3_2$... $3_N$), branché respectivement en aval, pour la production respectivement d'un signal filtré numérisé $y_1(n.T_A)$, $y_2(n.T_A)$...$y_N(n.T_A)$, moyennant quoi, dans chaque convertisseur analogique-numérique ($3_1$, $3_2$... $3_N$), a lieu respectivement un balayage avec un sous-échantillonnage et une unité d'égalisation et de découplage (8 ; 8' ; 8'' ; 8''') branchée respectivement en aval des convertisseurs analogique-numérique ($3_1$, $3_2$... $3_N$),
**caractérisé en ce que**
entre chaque convertisseur analogique-numérique ($3_1$, $3_2$... $3_N$) et l'unité d'égalisation et de découplage (8 ; 8' ; 8'' ; 8'''), est branché un transformateur de Fourier ($13_1$, $13_2$... $13_N$) pour la production d'un spectre $Y_1(k.\Delta f)$, $Y_2(k.\Delta f)$...$Y_N(k.\Delta f)$ correspondant respectivement au signal filtré numérisé $y_1(n.T_A)$, $y_2(n.T_A)$...$y_N(n.T_A)$ respectif et l'unité d'égalisation et de découplage (8 ; 8' ; 8'' ; 8''') contenant au moins un nombre N d'organes de multiplication ($14_{11}$, $14_{12}$...$14_{1N}$...$14_{21}$, $1422$...$14_{2N}$... $14_{M1}$, $14_{M2}$... $14_{MN}$), correspondant au nombre N de signaux filtrés $y_1(t)$, $y_2(t)$...$y_N(t)$, le signal à haute fréquence x(t) étant un signal Discrete-Multi-Tone ou un signal Orthogonal-Frequency-Division-Multiplexing et le signal Discrete-Multi-Tone ou le signal Orthogonal-Frequency-Division-Multiplexing comprenant des porteuses qui présentent, dans une zone de Nyquist d'ordre impair, une distance de fréquence $k.\Delta f$ par rapport à un bord inférieur de la zone de Nyquist et, dans une zone de Nyquist d'ordre pair, distance de fréquence $k.\Delta f$ par rapport à un bord supérieur de la zone de Nyquist, k étant un paramètre variable entier et $\Delta f$ étant une distance de fréquence entre deux porteuses adjacentes.

12. Dispositif selon la revendication 11,
**caractérisé en ce que**
les réponses en fréquence de filtrage de tous les filtres ($1_1$, $1_2$...$1_N$) recouvrent ensemble tout le spectre de fréquence du signal à haute fréquence x(t).

13. Dispositif selon la revendication 11 ou 12,
**caractérisé en ce que**
chaque convertisseur analogique-numérique ($3_1$, $3_2$... $3_N$) est relié avec une même horloge (6).

14. Dispositif selon l'une des revendications 11 à 13,
**caractérisé en ce que**
l'unité d'égalisation et de découplage (8 ; 8' ; 8'' ; 8''') contient au moins un nombre N de filtres d'égalisation ($10_{11}$, $10_{12}$... $10_{1N}$... $10_{21}$, $1022$... $10_{2N}$... $10_{M1}$, $10_{M2}$... $10_{MN}$) correspondant au nombre N de signaux filtrés $y_1(t)$, $y_2(t)$...$y_N(t)$.

15. Dispositif pour la réception d'au moins un signal à haute fréquence z(t) avec un traitement de signal de bande de base parallèle et sous-échantillonnée, comprenant respectivement un nombre de convertisseurs numérique-analogique ($19_1$, $19_2$... $19_N$) pour la production respectivement d'un signal analogique $v_1(t)$, $v_2(t)$...$v_N(t)$ à partir d'un signal de bande de base numérique $u_1(n.T_A)$, $u_2(n.TA)$...$u_N(n.T_A)$ correspondant, le nombre N de convertisseurs numérique-analogique ($19_1$, $19_2$... $19_N$) correspondant au nombre N de signaux de bande de base numériques $u_1(n.T_A)$, $u_2(n.T_A)$... $u_N(n.T_A)$ à transmettre respectivement dans le signal à haute fréquence z(t) et la fréquence de balayage des différents signaux de bande de base numériques étant inférieure au double de la fréquence spectrale la plus élevée dans le signal analogique correspondant, un filtre ($21_1$, $21_2$...$21_N$) branché respectivement en aval de chaque convertisseur numérique-analogique ($19_1$, $19_2$... $19_N$), pour la production d'un signal filtré $z_1(t)$, $z_2(t)$... $z_N(t)$ correspondant, la réponse en fréquence de filtrage des filtres ($21_1$, $21_2$... $21_N$) s'étendant, une fois additionnée, sur toutes les zones de Nyquist concernées et un organe d'addition (22) branché en aval respectivement des filtres ($21_1$, $21_2$...$21_N$), pour la production du signal à haute fréquence z(t) respectif,
le signal à haute fréquence y(t) étant un signal Discrete-Multi-Tone ou un signal Orthogonal-Frequency-Division-Multiplexing et le signal Discrete-Multi-Tone ou le signal Orthogonal-Frequency-Division-Multiplexing comprenant des porteuses qui présentent, dans une zone de Nyquist d'ordre impair, une distance de fréquence $k.\Delta f$ par rapport à un bord inférieur de la zone de Nyquist et, dans une zone de Nyquist d'ordre pair, distance de fréquence $k.\Delta f$ par rapport à un bord supérieur de la zone de Nyquist, k étant un paramètre variable entier et $\Delta f$ étant une distance de fréquence entre deux porteuses adjacentes.

16. Dispositif selon la revendication 15,

**caractérisé en ce que**
chaque convertisseur numérique-analogique ($19_1$, $19_2$... $19_N$) est relié avec une même horloge (20).

17. Système pour la transmission d'au moins un signal à haute fréquence avec un traitement de signal de bande de base parallèle et sous-échantillonné, avec un dispositif de réception d'au moins un signal à haute fréquence avec un traitement de signal de bande de base parallèle et sous-échantillonné selon l'une des revendications 11 à 14, un dispositif pour l'émission d'au moins un signal à haute fréquence avec un traitement de signal de bande de base parallèle et sous-échantillonné selon la revendication 15 ou 16 et un canal de transmission se trouvant entre le dispositif d'émission et le dispositif de réception.

FIG 1
Stand der Technik

FIG 2A

FIG 2B

FIG 3A

FIG 3B

Fig. 4

Start

S100 — parallelles Filtern des Hochfrequenzsignals in Filtern mit unterschiedlichen
Filterfrequenzgängen

S110 — Analog-Digital-Wandeln der einzelnen
gefilterten Signale in Unterabtastung

S120 — Spektral-Transformieren der einzelnen
digitalisierten gefilterten Signale

S130 — Bestimmen von digitalisierten Signalanteilen des
Hochfrequenzsignals in einzelnen Frequenzbändern
mittels Entzerren der Basisband-Spektralanteile
der einzelnen digitalisierten
gefilterten Signale

Ende

Fig. 5

Fig. 6

FIG 7

Fig. 8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 9264059 B2

- US 2005099327 A1

**In der Beschreibung aufgeführte Nicht-Patentliteratur**

- Synthesis of complex subband Hybrid Filter Banks A/D converters using adaptive filters. **ZHIGLIO SONG et al.** ELECTRONICS, CIRCUITS AND SYSTEMS, 2009, ICECS 2009, 16th IEEE INTERNATIONAL CONFERENCE ON. IEEE, 13. Dezember 2009, 399-402